# EUROPÄISCHE PATENTSCHRIFT

(11) **EP 3 599 318 B1**
(45) Veröffentlichungstag und Bekanntmachung des Hinweises auf die Patenterteilung: **10.11.2021**
(21) Anmeldenummer: 18186175.8
(22) Anmeldetag: 27.07.2018
(51) Int. Cl.: E04C 2/54, E06B 3/67

(54) **FASSADENELEMENTE MIT STRUKTURIERTER DECKPLATTE UND OPTISCHER INTERFERENZSCHICHT**
FAÇADE ELEMENTS WITH STRUCTURED COVER PLATE AND OPTICAL INTERFERENCE LAYER
ÉLÉMENTS DE FAÇADE POURVUS DE PLAQUE DE COUVERTURE STRUCTURÉE ET DE COUCHE D'INTERFÉRENCE OPTIQUE

(43) Veröffentlichungstag der Anmeldung: 29.01.2020
(73) Patentinhaber: (CNBM) Bengbu Design & Research Institute for Glass Industry Co., Ltd., 233010 Bengbu (CN)
(72) Erfinder: Palm, Jörg, 80797 München (DE); Tautenhahn, Lutz, 01277 Dresden (DE)
(74) Vertreter: Evans, Huw David Duncan

(56) Entgegenhaltungen:
- EP-A1- 3 208 402
- AT-A1- 512 678
- DE-A1- 1 797 168
- DE-A1- 10 104 347
- US-A- 3 185 034
- US-A- 3 255 665
- US-A- 3 393 034

## Beschreibung

Die vorliegende Erfindung liegt auf dem technischen Gebiet der Fassadenfertigung und betrifft farbige Fassadenelemente mit einer strukturierten Deckplatte und mindestens einer optischen Interferenzschicht. Die Fassadenelemente sollen insbesondere in Kombination mit farbigen Solarmodulen eingesetzt werden. Die Erfindung erstreckt sich weiterhin auf Verfahren zur Herstellung der erfindungsgemäßen Fassadenelemente.

Die Verwendung von Solarmodulen als Wand- bzw. Fassadenelemente ist derzeit ein wirtschaftlich noch relativ geringer, jedoch ökologisch sehr interessanter Markt. Insbesondere angesichts verstärkter Bemühungen für dezentrale Energielösungen und energie-neutrale Gebäude wächst der Bedarf für die Anwendung von Solarmodulen als integrierte Bestandteile von Gebäudehüllen. Weitere interessante Anwendungsbereiche für Solarmodule sind Lärmschutzwände (Straße, Schiene), Sichtschutzwände im Außenbereich oder Wände für Gewächshäuser. Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Je nach Ursprung der Farbe (Absorption/Remission, Interferenz, Brechung) kann die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

Die konkrekte Dimensionierung einer Fassade oder funktionaler Elemente wie Fenster, Türen und Balkone können erfordern, dass farbige Solarmodule in verschiedenen Größen und Formen benötigt werden, um der Fassade eine möglichst homogene Farbe zu geben. Generell führen kleinere und nicht rechteckförmige Solarmodule jedoch zu erheblichen Mehrkosten. Wenn der eigentliche Halbleiterstapel auf großer Fläche hergestellt wird und kleinere Modulgrößen durch Teilen erzeugt werden, kann dies bei kleineren Solarmodulen einen deutlich höheren Materialeinsatz pro Einheit Ausgangsleistung zur Folge haben. Zudem wird bei kleineren Solarmodulen das Verhältnis von Modulfläche zu Modulrand ungünstiger, so dass auch die Gesamtmodulwirkungsgrade kleiner sind. Ferner haben die Kosten von bestimmten Materialien und Fixkosten für Anbauteile und Randversiegelung bei kleinen Solarmodulen einen höheren Anteil an den Gesamtkosten. Des Weiteren können bestimmte Schritte des Herstellungsprozesses bei verschiedenen Substratgrößen nur mit stark modifizierten Anlagenkonzepten umgesetzt werden.

Grundsätzlich wäre die Herstellung von Solarmodulen in verschiedenen Größen und Formen technisch möglich, jedoch ist die industrielle Serienfertigung von Solarmodulen aus genannten Gründen auf einige wenige Standard-Modulgrößen und in aller Regel Rechteckform der Solarmodule ausgerichtet, so dass eine vollflächige Belegung einer Fassade mit Solarmodulen meist nicht möglich oder wirtschaftlich inakzeptabel ist. Hinzu kommt, dass die fotovoltaische Auslegung der Solarzellen und diverse Anbauteile wie Kontaktbänder, Anschlussdosen und Kabel für die Standard-Modulgrößen optimiert sind. Darüber hinaus kann es durch eine ungünstige Ausrichtung zur Sonne oder durch Verschattung durch Teile desselben Gebäudes oder durch benachbarte Gebäude unwirtschaftlich sein, bestimmte Bereiche einer Fassade mit Solarmodulen zu belegen, da deren Energieertrag nicht die Mehrkosten erwirtschaftet.

Um das Problem fehlender geeigneter Größen und/oder Formen für als Fassadenelemente verwendete farbige Solarmodule zu beheben, können fotovoltaisch passive Fassadenelemente aus Blech oder anderen herkömmlichen Baumaterialien verwendet werden, wobei es sich versteht, dass deren Farbe möglichst ähnlich zu jener der farbigen Solarmodule sein sollte. Hier gibt es aber ein technisches und gestalterisches Problem, das in der Natur der Farberzeugung liegt. Tatsächlich kann sich die Farbe der Solarmodule, je nach Ursprung der Farbe (Absorption/Remission, Interferenz, Brechung) bei unterschiedlichen Beleuchtungsverhältnissen, insbesondere abhängig von der Art des Lichtes (diffus, direkt, Lichtfarbe), sowie durch eine Änderung des Einstrahlwinkels und/oder Beobachtungswinkels verändern. Wenn die fotovoltaisch passiven Fassadenelemente aus anderen Materialien als die farbigen Solarmodule bestehen, entstehen hierdurch typischerweise Farbkontraste, die aus gestalterischen Gesichtspunkten unerwünscht sind.

EP 3208402 A1 offenbart ein Fassadenelement mit einer transparenten Deckplatte und einem opaken Rückseitenelement, wobei kein strukturierter Bereich und keine optische Interferenzschicht vorgesehen ist.

AT 512678 A1 offenbart ein Fassadenelement mit einer transparenten Deckplatte und einem opaken Rückseitenelement, wobei auf der Innenfläche der Deckplatte eine optische Interferenzschicht angeordnet ist. Die Innenfläche und/oder Außenfläche der Deckplatte weist einen strukturierten Bereich mit vorgegebenen Merkmalen auf.

Demgegenüber besteht die Aufgabe der vorliegenden Erfindung darin, ein farbiges Fassadenelement zur Verfügung zu stellen, dessen Farbe möglichst wenig von den Lichtverhältnissen sowie vom Betrachtungs- und Einstrahlwinkel abhängt. Je nach Technologie gibt es bei farbigen Solarmodulen eine verbleibende Winkelabhängigkeit. In diesem Fall soll das passive Fassadenelement die gleiche Winkelabhängigkeit aufweisen, so dass es keine unerwünschten optischen Kontraste zwischen Fassadenbereichen mit aktiven und solchen mit passiven Fassadenelementen gibt. Für eine industrielle Serienfertigung ist es zudem wichtig, dass die farbigen Fassadenelemente in verschiedenen Größen und Formen zu akzeptablen Kosten und mit zufriedenstellender Homogenität herstellbar sind. Die farbigen Fassadenelemente sollen insbesondere zur Ergänzung von farbigen Solarmodulen dienen, die als Fassadenelemente eingesetzt werden.

Diese und weitere Aufgaben werden nach dem Vorschlag der Erfindung durch fotovoltaisch passive (d.h. nicht zur fotovoltaischen Stromerzeugung geeignet und bestimmte) farbige Fassadenelemente und deren Herstellungsverfahren gemäß den nebengeordneten Patentansprüchen gelöst. Vorteilhafte Ausgestaltungen der Erfindung sind durch die Merkmale der Unteransprüche angegeben.

Wie hier und im Weiteren verwendet, bezieht sich der Begriff "Fassadenelement" auf ein Bauteil, das geeignet und bestimmt ist, als sichtbares Flächenelement in eine Fassade eingebaut zu werden. Generell weist die Fassade eine Außenseite und eine Innenseite auf, wobei die Außenseite der Fassade von der äußeren Umgebung her betrachtet werden kann. Die Fassade ist beispielsweise eine Gebäudewand oder eine freistehende Wand, die beispielsweise als Sicht- oder Lärmschutzwand dient. Das Fassadenelement kann als eigenständiger Bestandteil in eine Fassade integriert werden, wobei die Außenfläche des Fassadenelements Teil der Außenseite bzw. Außenfläche der Fassade ist.

Vorzugsweise wird das erfindungsgemäße farbige Fassadenelement in einer Fassade in Kombination mit farbigen Solarmodulen verwendet, deren Deckplatte mindestens einen strukturierten Bereich und mindestens eine optische Interferenzschicht aufweisen. Derartige Solarmodule sind in den nicht-veröffentlichten europäischen Patentanmeldungen EP18186153.5 und EP18186161.8 beschrieben. Hinsichtlich des Aufbaus und der Verwendung dieser Solarmodule wird auf die Offenbarung dieser beiden europäischen Patentanmeldungen vollumfänglich Bezug genommen.

Erfindungsgemäß ist ein farbiges Fassadenelement gezeigt, das eine transparente (vorderseitige) Deckplatte und ein an der Deckplatte angebrachtes opakes Rückseitenelement umfasst. Das opake Rückseitenelement ist photovoltaisch passiv, d.h. nicht zur fotovoltaischen Energieerzeugung geeignet. Die Deckplatte weist eine der äußeren Umgebung zugewandte Außenfläche und gegenüberliegend zur Außenfläche eine Innenfläche auf. Die Außenfläche der Deckplatte ist im verbauten Zustand des Fassadenelements in der Fassade der äußeren Umgebung zugewandt und bildet, gegebenenfalls mit hierauf aufgebrachten Schichten, einen Teil der Außenseite bzw. Außenfläche der Fassade. Das opake Rückseitenelement weist eine Kontaktfläche auf, die mit der Innenfläche der Deckplatte fest verbunden ist. Das Rückseitenelement bedeckt mindestens 70%, vorzugsweise wenigstens 90%, besonders bevorzugt wenigstens 99%, der Innenfläche der Deckplatte. Besonders bevorzugt bedeckt das Rückseitenelement die Innenfläche der Deckplatte vollflächig (zu 100%, d.h. vollständige Überdeckung). Die transparente Deckplatte ist frontseitig des Fassadenelements angeordnet.

Gemäß einer Ausgestaltung der Erfindung besteht die Deckplatte aus einem selben Material, beispielsweise Glas oder Kunststoff, vorzugsweise Kalknatronglas. Vorzugsweise ist die Deckplatte eine starre Glas- oder Kunststoffplatte. Die Außenfläche bzw. Innenfläche der Deckplatte wird in diesem Fall vom jeweiligen Material der Deckplatte gebildet. Gemäß einer alternativen Ausgestaltung der Erfindung besteht die Deckplatte aus mindestens zwei verschiedenen Materialien, wobei die Außenfläche und/oder Innenfläche der Deckplatte aus einem von einem Kern der Deckplatte verschiedenen Material gebildet wird. Der Kern der Deckplatte besteht vorzugsweise aus einem gleichen Material, beispielsweise Glas oder Kunststoff, vorzugsweise Kalknatronglas. Auf den Kern der Deckplatte ist außen- und/oder innenseitig ein vom Kern der Deckplatte verschiedenes Material angebracht, welches transparent ist und einen selben optischen Brechungsindex wie das Material des Kerns der Deckplatte hat. Die Außenfläche bzw. Innenfläche der Deckplatte wird in diesem Fall vom jeweiligen Material gebildet, das auf den Kern der Deckplatte aufgebracht ist. Erfindungsgemäß umfasst der Begriff "Deckplatte" somit auch Verbundkörper, mit der Maßgabe, dass die Materialien, welche die Deckplatte formen, transparent sind und einen gleichen optischen Brechungsindex haben.

Vorzugsweise weist die Deckplatte keine Krümmung auf und ist somit plan (eben). Die Deckplatte kann jedoch auch gekrümmt sein. Die Deckplatte kann starr oder biegsam sein. In Form einer biegsamen Deckplatte kann sie gleichsam in ebener Form bereitgestellt werden. Bei einer ebenen (planen) Deckplatte wird durch die Deckplatte selbst eine Ebene definiert, welche im Sinne der Erfindung als "Ebene der Deckplatte" zu verstehen ist. Bei einer gekrümmten Deckplatte kann durch eine (gedachte) ebene Tangentialfläche an einem beliebigen Punkt der Ebene eine lokale Ebene definiert werden, welche ebenfalls unter den Begriff "Ebene der Deckplatte" fällt.

Das opake Rückseitenelement ist rückseitig des Fassadenelements angeordnet. Das Rückseitenelement trägt zur Farbgebung des Fassadenelements bei. Zu diesem Zweck ist das Rückseitenelement beispielsweise unbunt, dunkel und matt ausgebildet. Möglich ist auch, dass das Rückseitenelement farbig ist, um in Kombination mit mindestens einer farbgebenden optischen Interferenzschicht, welche an der Deckplatte angeordnet ist, dem Fassadenelement einen bestimmten (vorgegebenen bzw. vorgebbaren) Farbeindruck zu vermitteln.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Die prozentualen Angaben beziehen sich auf die Intensität des Lichts, jeweils gemessen auf der einen Seite der Deckplatte bzw. des Rückseitenelements, bezogen auf die Intensität des auf der anderen Seite der Deckplatte bzw. des Rückseitenelements auftreffenden Lichts. Für eine solche Messung kann beispielsweise eine Weißlichtquelle (Quelle für sichtbares Licht) auf der einen Seite der Deckplatte bzw. des Rückseitenelements und ein Detektor für sichtbares Licht auf der anderen Seite der Deckplatte bzw. des Rückseitenelements angeordnet werden. Die nachfolgend genannten Werte für den optischen Brechungsindex beziehen sich immer auf den optischen Brechungsindex im sichtbaren Wellenlängenbereich von 380 nm bis 780 nm.

Das erfindungsgemäße Fassadenelement vermittelt dem Betrachter bei Beleuchtung von der Außenseite her mit weißem Licht, insbesondere bei Beleuchtung mit Sonnenlicht, in mindestens einem Abschnitt einen homogenen Farbeindruck, d.h. das Fassadenelement ist farbig. Vorzugsweise erstreckt sich der farbige Abschnitt über die komplette Außenfläche des Fassadenelements. Als besonders attraktiv gelten Fassadenelemente mit einem homogenen Farbeindruck auf der gesamten Fläche. Die Farbe des Fassadenelements kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farbort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleichbleibt und die Sättigung der Radius und h der Winkel eines Farbpunktes in der a*b*-Ebene ist.

Die Farbe des Fassadenelements bezieht sich auf eine Betrachtung von der äußeren Umgebung her, d.h. in Sicht auf die frontseitige Deckplatte. Die Farbmessung bzw. die Bestimmung der Farbkoordinaten des Fassadenelements kann in einfacher Weise durch ein im Handel verfügbares Farbmessgerät (Spektralphotometer) erfolgen. Das Farbmessgerät wird zu diesem Zweck auf die Außenfläche der frontseitigen Deckplatte gerichtet, insbesondere auf die Außenfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Außenfläche eines Körpers mit dem erzeugten (z.B. Weiß-)Licht beleuchtet und das vom Fassadenelement empfangene Licht gemessen wird. Wie eingangs erläutert, ergibt sich die vom Farbmessgerät gemessene Körperfarbe aus dem reflektierten und remittierten Licht des Fassadenelements.

Um zu erreichen, dass das erfindungsgemäße Fassadenelement zumindest in einem Abschnitt eine homogene Farbe hat, weist zumindest eine Oberfläche (d.h. Außenfläche und/oder Innenfläche) der Deckplatte mindestens einen strukturierten Bereich auf. Zudem ist mindestens eine farbgebende optische Interferenzschicht an der Deckplatte angeordnet. Dies wird im Weiteren näher erläutert.

Gemäß einem ersten Aspekt der Erfindung weist die Außenfläche der transparenten Deckplatte mindestens einen strukturierten Bereich auf, auf dem eine farbgebende (transparente) optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (ohne weitere Zwischenschicht) auf der Außenfläche der Deckplatte angeordnet. Die optische Interferenzschicht kann ein- oder mehrlagig ausgebildet sein, d.h. eine oder mehrere lichtbrechende Lagen (Brechungsschichten) aufweisen. Die optische Interferenzschicht dient zur Erzeugung der Farbe des Fassadenelements, wobei die optische Interferenzschicht so ausgebildet ist, dass eine konstruktive bzw. destruktive Interferenz von Licht, das an den verschiedenen Grenzflächen der optischen Interferenzschicht reflektiert wird, möglich ist. Die Farbe des Fassadenelements ergibt sich aus der Interferenz des an den Grenzflächen der optischen Interferenzschicht reflektierten Lichts. Bei Beleuchtung mit (Weiß-)Licht, insbesondere Sonnenlicht, wirkt die optische Interferenzschicht als Farbfilter zur Erzeugung einer homogenen Farbe. Vorzugsweise erstreckt sich der strukturierte Bereich der Außenfläche über die komplette Deckplatte, d.h. über die komplette Außenfläche der Deckplatte, so dass das komplette Fassadenelement eine homogene Farbe hat. Das Fassadenelement kann auch mehrere Fassadenelementabschnitte mit jeweils homogener Farbe aufweisen. Die Farben der Fassadenelementabschnitte können gleich oder voneinander verschieden sein.

Der mindestens eine strukturierte Bereich weist senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20% einer Dicke der transparenten Deckplatte beträgt. Ferner setzen sich mindestens 50% des strukturierten Bereichs der Außenfläche aus unterschiedlich geneigten Segmenten bzw. Facetten zusammen. Die Segmente sind Abschnitte der zur äußeren Umgebung gerichteten Oberfläche der Deckplatte und jeweils als plane Flächen ausgebildet, die zur Ebene der Deckplatte geneigt sind. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen.

Ferner sind die Segmente jeweils eben (plan) und haben eine Segmentfläche von mindestens 1 µm². Weiterhin gilt, dass in mindestens einer Zone (d.h. Teilbereich) des strukturierten Bereichs die Segmente jeweils eine mittlere Rauigkeit von weniger als 15% einer Schichtdicke der optischen Interferenzschicht, welche auf den strukturierten Bereich aufgebracht ist, haben. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch. Der strukturierte Bereich kann beispielsweise durch Ätzen, Sandstrahlen oder Walzen der Deckplatte hergestellt werden.

Demnach weist der mindestens eine strukturierte Bereich der Deckplatte des Fassadenelements gemäß dem esten Aspekt der Erfindung eine Vielzahl von ebenen (planen) Segmenten auf. Im Sinne vorliegender Erfindung können ebene (plane) Segmente durch nicht-gekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Im Sinne vorliegender Erfindung bezeichnet der Begriff "Strukturierung" bzw. "strukturierter Bereich" im Zusammenhang mit dem Fassadenelement gemäß dem ersten Aspekt der Erfindung einen Bereich der Außenfläche oder Innenfläche der Deckplatte, in dem die im unmittelbar vorstehenden Absatz beschriebenen Merkmale in Kombination vorliegen.

Durch die Merkmale des strukturierten Bereichs kann in vorteilhafter Weise erreicht werden, dass bei Beleuchtung der Deckplatte mit Licht auch bei einer Beobachtung außerhalb des Glanzwinkels (Einfallswinkel des auftreffenden Lichts entspricht Ausfallswinkel des reflektierten Lichts, bezogen auf die Ebene der Deckplatte) Licht mit relativ hoher Intensität zurückgeworfen wird. Ursache hierfür sind die verschieden geneigten Segmente, die in ausreichender Anzahl, geeigneter Größe und geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Brechung an den Segmenten und bei Strukturierung innen durch Reflexion an den Segmenten genügend Intensität in Richtungen außerhalb des Glanzwinkels der Deckplatte streuen.

Wie hier und im Weiteren verwendet, bezieht sich der Begriff "Glanzwinkel" auf die Normale zur Ebene der Deckplatte, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der Deckplatte), sind jedoch in aller Regel verschieden (Segment ist geneigt zur Ebene der Deckplatte).

Im Ergebnis kann erreicht werden, dass die Intensität des nicht im Glanzwinkel reflektierten (d.h. gestreuten) Lichts relativ hoch ist und im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der optischen Interferenzschicht kann das außerhalb des Glanzwinkels reflektierte Licht, abhängig von Brechungsindex und Schichtdicke der optischen Interferenzschicht, einer Farbselektion unterzogen werden, so dass die Oberfläche der Deckplatte eine homogene Farbe mit relativ geringer Winkelabhängigkeit hat. Die Interferenzschicht wirkt als Filter mit möglichst schmalbandiger Reflexion und einer breitbandigen Transmission.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der Deckplatte (z.B. Deckglas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der Deckplatte (z.B. Deckglas) erzeugt werden. Dementsprechend erstreckt sich die Erfindung vorteilhaft auf ein Fassadenelement, dessen mindestens ein strukturierter Bereich der Deckplatte durch Ätzen oder Walzen hergestellt ist, wodurch die genannten Höhenprofile herstellbar sind. Die Strukturen können aber auch durch das Aufbringen einer transparenten und strukturierten Schicht auf die Deckplatte erzeugt werden. Die Schicht muss dabei einen gleichen (oder zumindest sehr ähnlichen) Brechungsindex haben wie die Deckplatte. Erfindungsgemäß soll das Strukturieren einer Oberfläche der Deckplatte auch das Aufbringen einer solchen transparenten und strukturierten Schicht umfassen.

Die genannten Eigenschaften des strukturierten Bereichs der Deckplatte können durch herkömmliche Messgeräte, wie ein Mikroskop, insbesondere ein Konfokalmikroskop, oder ein Nadelprofilometter, bestimmt werden.

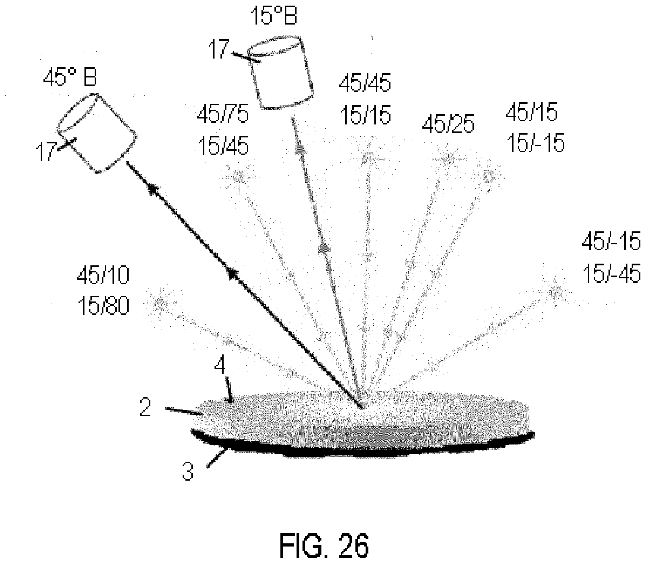

Vorzugsweise wird durch den mindestens einen strukturierten Bereich der (unbeschichteten) Deckplatte des erfindungsgemäßen Fassadenelements gemäß dem ersten Aspekt der Erfindung erreicht, dass bei Beobachtungswinkeln von 45° und 15° (jeweils bezogen auf die Ebene der Deckplatte) und einem Einfallswinkel, der um 45° vom jeweiligen Glanzwinkel abweicht (in beiden Richtungen), eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite (d.h. Innenfläche) der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 26 näher erläutert. In diesem Zusammenhang wird auf die europäische Norm EN ISO 11664-4 in vollem Umfang Bezug genommen.

Die Erfindung erstreckt sich demnach gemäß dem ersten Aspekt der Erfindung auf ein Fassadenelement, umfassend eine transparente Deckplatte und ein an der Deckplatte angebrachtes opakes Rückseitenelement, wobei die Deckplatte eine der äußeren Umgebung zugewandte Außenfläche und eine dem Rückseitenelement zugewandte Innenfläche hat, wobei die Außenfläche mindestens einen strukturierten Bereich aufweist, auf dem eine optische Interferenzschicht zur Reflexion von Licht innerhalb eines vorgegebenen Wellenlängenbereichs angeordnet ist, wobei der strukturierte Bereich folgende Merkmale hat:
- senkrecht zur Ebene der Deckplatte ein Berge und Täler aufweisendes Höhenprofil, wobei ein mittlerer Höhenunterschied zwischen den Bergen und Tälern mindestens 2 µm beträgt,
- mindestens 50% des strukturierten Bereichs setzt sich aus Segmenten zusammen, die zur Ebene der Deckplatte geneigt sind, wobei, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- die Segmente jeweils eben sind und eine Segmentfläche von mindestens 1 µm² haben, wobei die Segmente jeweils eine mittlere Rauigkeit von weniger als 15% einer Schichtdicke der optischen Interferenzschicht auf der Außenfläche haben.

Hierbei ist es von Vorteil, wenn die mit einer schwarzen Rückfläche versehene, strukturierte, unbeschichtete Deckplatte so ausgebildet ist, dass bei einem Beobachtungswinkel von 45° und 15° (jeweils bezogen auf die Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Die Erfindung erstreckt sich gemäß dem ersten Aspekt der Erfindung gleichermaßen auf ein Fassadenelement, umfassend eine transparente Deckplatte und ein an der Deckplatte angebrachtes opakes Rückseitenelement, wobei die Deckplatte eine der äußeren Umgebung zugewandte Außenfläche und eine dem Rückseitenelement zugewandte Innenfläche hat, wobei die Außenfläche mindestens einen strukturierten Bereich aufweist, auf dem eine optische Interferenzschicht zur Reflexion von Licht innerhalb eines vorgegebenen Wellenlängenbereichs angeordnet ist, wobei die mit einer schwarzen Rückfläche versehene, mindestens einen strukturierten Bereich aufweisende, unbeschichtete Deckplatte so ausgebildet ist, dass bei einem Beobachtungswinkel von 45° und 15° (jeweils bezogen auf die Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Bei einer bevorzugten Ausgestaltung des erfindungsgemäßen Fassadenelements gemäß dem ersten Aspekt der Erfindung ist die Außenfläche der Deckplatte mit mindestens einem strukturierten Bereich versehen, auf dem eine farbgebende optische Interferenzschicht angeordnet ist. Zudem weist die Innenfläche der Deckplatte keinen strukturierten Bereich und keine optische Interferenzschicht auf. Die Innenfläche ist vorzugsweise glatt (im Rahmen der Produktionsungenauigkeiten). Die optische Interferenzschicht ist vorzugsweise unmittelbar (d.h. ohne weitere Zwischenschicht) auf der Außenfläche der Deckplatte angeordnet.

Bei einer weiteren bevorzugten Ausgestaltung des erfindungsgemäßen Fassadenelements gemäß dem ersten Aspekt der Erfindung ist die Außenfläche der Deckplatte mit mindestens einem strukturierten Bereich versehen, auf dem eine farbgebende optische Interferenzschicht angeordnet ist. Zudem weist die Innenfläche keinen strukturierten Bereich auf, wobei auf der Innenfläche der Deckplatte eine weitere optische Interferenzschicht zur Reflexion von Licht innerhalb eines vorgegebenen Wellenlängenbereichs angeordnet ist. Die Innenfläche ist vorzugsweise glatt (im Rahmen der Produktionsungenauigkeiten). Obige Ausführungen zur optischen Interferenzschicht auf der Außenfläche der Deckplatte gelten in analoger Weise für die optische Interferenzschicht auf der Innenfläche der Deckplatte. Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Die Schichtdicken und Brechungsindizes der beiden optischen Interferenzschichten können gleich oder voneinander verschieden sein. Durch diese Maßnahme kann die Farbe des Fassadenelements noch besser definiert werden. Zudem können Mischfarben generiert werden.

Bei einer weiteren bevorzugten Ausgestaltung des erfindungsgemäßen Fassadenelements gemäß dem ersten Aspekt der Erfindung ist die Außenfläche der Deckplatte mit mindestens einem strukturierten Bereich versehen, auf dem eine farbgebende optische Interferenzschicht angeordnet ist. Zudem weist die Innenfläche mindestens einen strukturierten Bereich auf, auf dem eine optische Interferenzschicht zur Reflexion von Licht innerhalb eines vorgegebenen Wellenlängenbereichs angeordnet ist. Obige Ausführungen zum strukturierten Bereich der Außenfläche der Deckplatte gelten in analoger Weise für den strukturierten Bereich der Innenfläche der Deckplatte. Der strukturierte Bereich der Innenfläche und der strukturierte Bereich der Außenfläche können gleich oder voneinander verschieden sein. Für die weitere optische Interferenzschicht auf der Innenfläche der Deckplatte gelten die diesbezüglichen Ausführungen in unmittelbar vorgestehender Ausgestaltung des Fassadenelements in analoger Weise, wobei die Schichtdicken und Brechungsindizes der beiden optischen Interferenzschichten gleich oder voneinander verschieden sein können. Auch durch diese Maßnahmen kann die Farbe des Fassadenelements noch besser definiert werden. Zudem können Mischfarben generiert werden.

Allen oben beschriebenen Ausgestaltung gemäß des ersten Aspektes der Erfindung ist gemeinsam, dass bereits beim Auftreffen des Lichts auf die strukturierte Außenfläche mit Interferenzschicht durch Reflexion und Interferenz eine Farbe mit hohen Intensität und geringer Winkelabhängigkeit auch außerhalb des Glanzwinkels entsteht. Die zusätzlichen Interferenzschichten und/oder Strukturierungen auf der Innenfläche können diese Wirkung noch verstärken.

Gemäß einem zweiten Aspekt der Erfindung ist ein Fassadenelement mit einer transparenten Deckplatte und einem an der Deckplatte angebrachten opaken Rückseitenelement gezeigt. Um unnötige Wiederholungen zu vermeiden, werden die Unterschiede zum Fassadenelement gemäß dem ersten Aspekt der Erfindung beschrieben und ansonsten wird auf obige Ausführungen Bezug genommen. Insbesondere gelten obige Ausführungen zu der/den optischen Interferenzschicht(en) in analoger Weise. Jedoch unterscheidet sich der mindestens eine strukturierte Bereich der Deckplatte des Fassadenelements gemäß dem zweiten Aspekt der Erfindung von dem mindestens einen strukturierten Bereich der Deckplatte des Fassadenelements gemäß dem ersten Aspekt der Erfindung, wie weiter unten erläutert wird.

In dem Fassadenelement gemäß dem zweiten Aspekt der Erfindung ist auf der Innenfläche der Deckplatte eine farbgebende optische Interferenzschicht zur Reflexion von Licht innerhalb eines vorgegebenen bzw. vorgebbaren Wellenlängenbereichs angeordnet. Die optische Interferenzschicht ist vorzugsweise unmittelbar (ohne weitere Zwischenschicht) auf der Innenfläche der Deckplatte angeordnet. Zudem weist die Innenfläche und/oder die Außenfläche der Deckplatte jeweils mindestens einen strukturierten Bereich auf, mit der Maßgabe, dass entweder die Außenfläche mindestens einen strukturierten Bereich aufweist oder auf der Außenfläche eine weitere optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (ohne weitere Zwischenschicht) auf der Außenfläche der Deckplatte angeordnet. Dies bedeutet, dass keine optische Interferenzschicht auf der Außenfläche angeordnet ist, wenn die Außenfläche mindestens einen strukturierten Bereich aufweist.

Wie weiter unten erläutert, ist allen Ausgestaltungen dieses zweiten Aspektes der Erfindung gemeinsam, dass das Licht mindestens einmal die Deckplatte passieren und an der innenliegenden Interferenzschicht reflektiert werden muss, um die gewünschte Farbigkeit mit der verbesserten Winkelstabilität zu erreichen.

Der mindestens eine strukturierte Bereich der Deckplatte des Fassadenelements gemäß dem zweiten Aspekt der Erfindung weist senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20% einer Dicke der transparenten Deckplatte beträgt. Ferner setzen sich mindestens 50% des strukturierten Bereichs der Außenfläche aus unterschiedlich geneigten Segmenten bzw. Facetten zusammen. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen. Falls die Innenfläche mindestens einen strukturierten Bereich aufweist, sind die Segmente des strukturierten Bereichs der Innenfläche jeweils eben, haben eine Segmentfläche von mindestens 1 µm² und eine mittlere Rauigkeit von weniger als 15% einer Schichtdicke der optischen Interferenzschicht auf der Innenfläche. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch. Die Bedingung für die Rauigkeit der Segmente muss grundsätzlich nur erfüllt werden, falls eine optische Interferenzschicht auf einem strukturierten Bereich angeordnet ist. Dies trifft nur für den mindestens einen strukturierten Bereich der Innenfläche zu. Falls die Außenfläche mindestens einen strukturierten Bereich aufweist, gibt es keine Bedingung für die Rauigkeit der Segmente des strukturierten Bereichs, weil die Außenfläche entweder mindestens einen strukturierten Bereich aufweist oder eine optische Interferenzschicht auf der Außenfläche angeordnet ist, jedoch keine optische Inferferenzschicht auf einem strukturierten Bereich der Außenfläche.

Demnach, für den Fall, dass die Innenfläche mindestens einen strukturierten Bereich aufweist, verfügt der strukturierte Bereich über eine Vielzahl von ebenen (planen) Segmenten. Im Sinne vorliegender Erfindung können ebene (plane) Segmente durch nicht-gekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Im Sinne vorliegender Erfindung bezeichnet der Begriff "Strukturierung" bzw. "strukturierter Bereich" im Zusammenhang mit dem Fassadenelement gemäß dem zweiten Aspekt der Erfindung einen Bereich der Außenfläche oder Innenfläche der Deckplatte, in dem die im unmittelbar vorstehenden Absatz beschriebenen Merkmale in Kombination vorliegen.

Durch die innen und/oder außen strukturierte Oberfläche der Deckplatte wird Licht mit einer hohen Intensität und geringer Winkelabhängigkeit auch außerhalb des Glanzwinkels reflektiert, da die innen liegende Interferenzschicht eine Grenzfläche mit höherem Brechungsindex darstellt. Bei außen liegender Strukturierung wird das Licht bereits an der Grenzfläche Luft und Deckplatte gebrochen und trifft diffus gestreut aus verschiedensten Winkeln auf die innen liegende Interferenzschicht. Bei nur innen liegender Strukturierung findet die diffuse Streuung an dieser inneren Grenzfläche statt, da erfindungsgemäß viele Oberflächensegmente mit unterschiedlichen Neigungswinkeln zur Verfügung stehen. Zudem wird durch die farbgebende optische Interferenzschicht ein guter homogener Farbeindruck erreicht. Die Interferenzschicht wirkt als Filter mit möglichst schmalbandiger Reflexion und einer breitbandigen Transmission.

Vorzugsweise wird durch den mindestens einen strukturierten Bereich der (unbeschichteten) Deckplatte des erfindungsgemäßen Fassadenelements gemäß dem zweiten Aspekt erreicht, dass bei Beobachtungswinkeln von 45° und 15° (jeweils bezogen auf die Normale zur Ebene der Deckplatte) und einem Einfallswinkel, der um 45° vom jeweiligen Glanzwinkel abweicht (in beiden Richtungen), eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite (d.h. Innenfläche) der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 26 näher erläutert. In diesem Zusammenhang wird auf die europäische Norm EN ISO 11664-4 in vollem Umfang Bezug genommen.

Die Erfindung erstreckt sich demnach gemäß dem zweiten Aspekt der Erfindung auf ein Fassadenelement, umfassend eine transparente Deckplatte und ein an der Deckplatte angebrachtes opakes Rückseitenelement, wobei die Deckplatte eine der äußeren Umgebung zugewandte Außenfläche und eine dem Rückseitenelement zugewandte Innenfläche hat, wobei auf der Innenfläche eine optische Interferenzschicht zur Reflexion von Licht innerhalb eines vorgegebenen Wellenlängenbereichs angeordnet ist, wobei die Innenfläche und/oder die Außenfläche jeweils mindestens einen strukturierten Bereich aufweist, wobei entweder die Außenfläche mindestens einen strukturierten Bereich aufweist oder auf der Außenfläche eine weitere optische Interferenzschicht zur Reflexion von Licht innerhalb eines vorgegebenen Wellenlängenbereichs angeordnet ist, wobei der strukturierte Bereich folgende Merkmale hat:
- senkrecht zur Ebene der Deckplatte ein Berge und Täler aufweisendes Höhenprofil, wobei ein mittlerer Höhenunterschied zwischen den Bergen und Tälern mindestens 2 µm beträgt,
- mindestens 50% des strukturierten Bereichs setzt sich aus Segmenten zusammen, die zur Ebene der Deckplatte geneigt sind, wobei, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- falls die Innenfläche mindestens einen strukturierten Bereich aufweist, die Segmente des strukturierten Bereichs der Innenfläche jeweils eben sind, eine Segmentfläche von mindestens 1 µm² und eine mittlere Rauigkeit von weniger als 15% einer Schichtdicke der optischen Interferenzschicht auf der Innenfläche haben.

Die Erfindung erstreckt sich gemäß dem zweiten Aspekt der Erfindung gleichermaßen auf ein Fassadenelement, umfassend eine transparente Deckplatte und ein an der Deckplatte angebrachtes opakes Rückseitenelement, wobei die Deckplatte eine der äußeren Umgebung zugewandte Außenfläche und eine dem Rückseitenelement zugewandte Innenfläche hat, wobei auf der Innenfläche eine optische Interferenzschicht zur Reflexion von Licht innerhalb eines vorgegebenen Wellenlängenbereichs angeordnet ist, wobei die Innenfläche und/oder die Außenfläche jeweils mindestens einen strukturierten Bereich aufweist, wobei entweder die Außenfläche mindestens einen strukturierten Bereich aufweist oder auf der Außenfläche eine weitere optische Interferenzschicht zur Reflexion von Licht innerhalb eines vorgegebenen Wellenlängenbereichs angeordnet ist, wobei die mit einer schwarzen Rückfläche versehene, mindestens einen strukturierten Bereich aufweisende, unbeschichtete Deckplatte so ausgebildet ist, dass bei einem Beobachtungswinkel von 45° und 15° (jeweils bezogen auf die Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Bei einer bevorzugten Ausgestaltung des erfindungsgemäßen Fassadenelements gemäß dem zweiten Aspekt der Erfindung ist auf der Innenfläche der Deckplatte eine optische Interferenzschicht angeordnet, wobei die Innenfläche der Deckplatte keinen strukturierten Bereich aufweist und die Außenfläche mindestens einen strukturierten Bereich aufweist, wobei keine weitere optische Interferenzschicht auf der Außenfläche angeordnet ist. Die Innenfläche ist vorzugsweise glatt (im Rahmen der Produktionsungenauigkeiten). Für die Segmente des strukturierten Bereichs der Außenfläche des Fassadenelements gibt es keine Bedingung für die Rauigkeit. Die strukturierte Außenfläche kann auch größere mikroskopische Rauigkeit aufweisen. An dieser Grenzfläche findet nur Transmission, Brechung und Streuung, jedoch keine Interferenz statt. Bei dieser Ausgestaltung des erfindungsgemäßen Fassadenelements kann es vorteilhaft sein, wenn die Außenfläche der Deckplatte mit einer (z.B. dünnen) Antireflexschicht beschichtet ist, deren optischer Brechungsindex kleiner ist als jener der Deckplatte. Hierdurch kann eine im Wesentlichen weiße Reflexion einer Deckplatte (z.B. Glas) unterdrückt werden und der Sättigungsgrad der Farben steigt. Eine zusätzliche Schicht auf der Außenfläche kann aber auch den gleichen Brechungsindex wie die Deckplatte aufweisen. In diesem Fall dient die Schicht nur dem Schutz der Deckplatte vor Feuchte und anderen korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Bei einer weiteren bevorzugten Ausgestaltung des erfindungsgemäßen Fassadenelements gemäß dem zweiten Aspekt der Erfindung ist auf der Innenfläche der Deckplatte eine optische Interferenzschicht angeordnet, wobei die Innenfläche der Deckplatte mindestens einen strukturierten Bereich aufweist und die Außenfläche mindestens einen strukturierten Bereich aufweist, wobei keine weitere optische Interferenzschicht auf der Außenfläche angeordnet ist. Der strukturierte Bereich der Innenfläche und der strukturierte Bereich der Außenfläche können gleich oder voneinander verschieden sein. Für die Segmente des strukturierten Bereichs der Außenfläche des Fassadenelements gibt es keine Bedingung für die Rauigkeit. Die strukturierte Außenfläche kann auch größere mikroskopische Rauigkeit aufweisen. An dieser Grenzfläche findet nur Transmission, Brechung und Streuung, jedoch keine Interferenz statt. Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Wenn die Außenfläche strukturiert ist und die Interferenzschicht auf der Innenfläche liegt, entsteht die Winkelstabilität daraus, dass das Licht beim Eintritt durch die strukturierte Außenfläche an den unterschiedlich geneigten Segmenten gebrochen wird, in verschiedenen Winkeln auf die Interferenzschicht trifft und nach Interferenz und Reflexion ein weiteres Mal die strukturierte Außenfläche beim Austritt aus der Deckplatte passiert und dabei wiederum durch Brechung seine Richtung ändert.

Bei einem erfindungsgemäßen Fassadenelement gemäß dem zweiten Aspekt der Erfindung ist auf der Innenfläche der Deckplatte eine optische Interferenzschicht angeordnet, wobei die Innenfläche der Deckplatte mindestens einen strukturierten Bereich aufweist und die Außenfläche keinen strukturierten Bereich aufweist, wobei keine weitere optische Interferenzschicht auf der Außenfläche angeordnet ist. Die Außenfläche ist vorzugsweise glatt (im Rahmen der Produktionsungenauigkeiten). Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Bei dieser Ausgestaltung des erfindungsgemäßen Fassadenelements kann es vorteilhaft sein, wenn die Außenfläche der Deckplatte mit einer (z.B. dünnen) Antireflexschicht beschichtet ist, deren Brechungsindex kleiner ist als jener der Deckplatte. Hierdurch kann eine im Wesentlichen weiße Reflexion einer gläsernen Deckplatte unterdrückt werden und der Sättigungsgrad der Farben steigt.

Bei einer weiteren bevorzugten Ausgestaltung des erfindungsgemäßen Fassadenelements gemäß dem zweiten Aspekt der Erfindung ist auf der Innenfläche der Deckplatte eine optische Interferenzschicht angeordnet, wobei die Innenfläche der Deckplatte mindestens einen strukturierten Bereich aufweist und die Außenfläche keinen strukturierten Bereich aufweist, wobei eine weitere optische Interferenzschicht auf der Außenfläche angeordnet ist. Die Außenfläche ist vorzugsweise glatt (im Rahmen der Produktionsungenauigkeiten). Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Die Interferenzschicht auf der glatten Außenseite kann auch eine farbneutrale Antireflexschicht sein, um den Weißanteil des insgesamt reflektierten Lichtes zu reduzieren. Die Farbe wird durch Reflexion an der strukturierten Innenseite mit der Interferenzschicht erzeugt. Die Interferenzschicht an der glatten Außenseite kann aber auch eine farbgebende Schicht sein, die die an der Innenseite generierte Farbe verstärkt oder eine weitere Farbkomponente in einem andern Wellenlängenbereich dazu mischt.

Allen oben beschriebenen Ausgestaltungen des zweiten Aspekts der Erfindung ist gemeinsam, dass das Licht mindestens einmal die Deckplatte passieren und an der innenliegenden Interferenzschicht reflektiert werden muss, um nach Austritt aus der Außenfläche die gewünschte Farbigkeit mit der verbesserten Winkelstabilität zu erreichen.

Die folgenden Ausführungen beziehen sich gleichermaßen auf das Fassadenelement gemäß dem ersten und zweiten Aspekt der Erfindung.

In dem erfindungsgemäßen Fassadenelement wird durch die strukturierte Deckplatte Licht mit einer hohen Intensität und geringer Winkelabhängigkeit auch außerhalb des Glanzwinkels reflektiert. Durch die mindestens eine optische Interferenzschicht, welche farbgebend wirkt, wird ein sehr homogener Farbeindruck erzeugt.

Bei einer vorteilhaften Ausgestaltung des erfindungsgemäßen Fassadenelements setzen sich mindestens 80%, besonders bevorzugt mindestens 90%, eines strukturierten Bereichs der Außenfläche oder der Innenfläche (je nachdem welche Fläche strukturiert ist) aus den zur Ebene der Deckplatte geneigten Segmenten zusammen. Durch die Vergrößerung der Anzahl der Segmente kann die Intensität des vom strukturierten Bereich der Oberfläche der Deckplatte auch außerhalb des Glanzwinkels reflektierten Lichts und dessen Winkelstabilität noch weiter gesteigert werden.

Bei einer weiteren vorteilhaften Ausgestaltung des erfindungsgemäßen Fassadenelements haben mindestens 30% der Segmente mindestens eines strukturierten Bereichs einen Neigungswinkel im Bereich von größer als 0° bis maximal 15°, mindestens 40% der Segmente einen Neigungswinkel im Bereich von größer als 15° bis maximal 45° und vorzugsweise, jedoch nicht zwingend, weniger als 10% der Segmente einen Neigungswinkel von größer als 45°. Besonders bevorzugt haben mindestens 40% der Segmente einen Neigungswinkel im Bereich von größer als 0° bis maximal 15°, mindestens 50% der Segmente einen Neigungswinkel im Bereich von größer als 15° bis maximal 45° und vorzugsweise, jedoch nicht zwingend, weniger als 10% der Segmente einen Neigungswinkel von größer als 45°. Falls relativ viele Facetten mit einem kleinen Neigungswinkel von weniger als 15° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Bei steileren Facetten verringert sich die Winkelabhängigkeit des reflektierten Lichts, jedoch können bei zahlreichen sehr steilen Facetten (größer als 45°) verstärkt Mehrfach-Reflexionen auftreten, was nachteilig ist. Zudem ist es bei vielen Beschichtungsverfahren schwierig, eine konforme Bedeckung mit gleicher Schichtdicke gleichzeitig auf flachen und steilen Oberflächensegmente zu gewährleisten. Die Schichtdicke der Interferenzschicht würde also vom Neigungswinkel abhängen, was wiederum zu unerwünschten Winkelabhängigkeiten führt.

In dieser Hinsicht am meisten bevorzugt ist eine Ausgestaltung, bei der die Segmente jeweils einen Neigungswinkel aufweisen, der größer als 0° ist und maximal 45° beträgt. Gemäß vorstehender Bedingungen kann eine sehr hohe Intensität des reflektierten Lichts auch außerhalb des Glanzwinkels bei zugleich besonders geringer Winkelabhängigkeit der Intensität erreicht werden. Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz und Farbeffekten verwendet werden. Wenn die Oberflächenstrukturen die oben genannten Bedingungen erfüllen, zeigen die Fassadenelemente wiederum eine deutlich verringerte Abnahme der Farbigkeit für Winkel außerhalb der Glanzwinkel, jedoch sind die Winkelabhängigkeiten dann anisotrop in Bezug auf die Orientierung in der Ebene der Deckplatte.

Die mindestens eine optische Interferenzschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält die optische Interferenzschicht mehrere Brechungsschichten, bestehen mindestens zwei Brechungsschichten aus einem voneinander verschiedenen Material und haben einen unterschiedlichen Brechungsindex. Vorteilhaft weist mindestens eine Brechungsschicht einen Brechungsindex n von größer als 1,7, vorzugsweise größer als 2,0 und besonders bevorzugt größer als 2,3 auf. Grundsätzlich gilt, dass je größer der Brechungsindex ist, desto geringer ist die Winkelabhängigkeit des reflektierten Lichts, so dass die Winkelabhängigkeit des Farbeindrucks weiter reduziert werden kann.

Vorteilhaft enthält die optische Interferenzschicht mindestens eine Verbindung, gewählt aus TiOₓ, ZrOₓ, SiC und Si₃N₄. Weist die optische Interferenzschicht zwei, drei oder mehr Lagen auf, enthält die optische Interferenzschicht vorzugsweise mindestens eine Verbindung, gewählt aus MgF2, Al₂O₃, SiO₂ und Siliziumoxinitrid. Dies sind Verbindungen mit einem relativ niedrigen Brechungsindex.

In dem erfindungsgemäßen Fassadenelement kann aufgrund der Kombination einer strukturierten Oberfläche mit einer optischen Interferenzschicht, die nur eine geringe Anzahl an Brechungsschichten aufweist (z.B. ein bis drei Brechungsschichten) schon ein guter Farbeindruck erreicht werden. Durch die geringe Anzahl an Brechungsschichten wird die Herstellung des Fassadenelements vereinfacht und die Produktionskosten verringern sich.

Vorteilhaft enthält mindestens eine optische Interferenzschicht (insbesondere alle optischen Interferenzschichten) des Fassadenelements genau eine Brechungsschicht (oder besteht aus dieser), deren Brechungsindex n größer als 1,9, bevorzugt größer als 2,3, ist.

Gleichermaßen vorteilhaft enthält mindestens eine optische Interferenzschicht (insbesondere alle optischen Interferenzschichten) des Fassadenelements genau zwei Brechungsschichten (oder besteht aus diesen), wobei eine erste Brechungsschicht mit einen ersten Brechungsindex n1 auf der Deckplatte mit einem Brechungsindex nd vorliegt und eine zweite Brechungsschicht mit einem zweiten Brechungsindex n2 auf der ersten Brechungsschicht vorliegt. Für die Beträge (Absolutwerte) der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Gleichermaßen vorteilhaft enthält mindestens eine optische Interferenzschicht (insbesondere alle optischen Interferenzschichten) des Fassadenelements genau drei Brechungsschichten (oder besteht aus diesen), wobei eine erste Brechungsschicht mit einen ersten Brechungsindex n1 auf der Deckplatte mit einem Brechungsindex nd vorliegt, eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Für die Beträge (Absolutwerte) der Differenzen der Brechungsindizes gilt: |n3-n2| > 0,3 und |n2-n| > 0,3 und |n1-nd| > 0,3. Dabei verhalten sich die Werte der Brechungsindizes alternierend: entweder gilt n1 > n2 und n3 > n2 oder es gilt n1 < n2 und n3 < n2. Zudem ist mindestens einer der Brechungsindizes n1, n2 oder n3 größer als 1,9, bevorzugt größer als 2,3.

Durch die optischen Interferenzschichten mit genau einer, genau zwei oder genau drei Brechungsschichten kann bei vereinfachter Herstellung und geringeren Produktionskosten des Fassadenelements ein homogener Farbeindruck des Fassadenelements erzielt werden. Durch zwei- oder dreilagige Schichten kann die Farbkraft, d.h. Helligkeit und Sättigung, also die Reflexion in einem bestimmten engen Wellenbereich erhöht werden. Durch relativ hohe Brechungsindizes wird die Winkelabhängigkeit reduziert. Interferenzschichten aus Schichtstapeln mit mehr als drei Schichten in Kombination mit der erfindungsgemäß strukturierten Deckplatte und den dargestellten Ausgestaltungen liegen ebenfalls im Bereich der Erfindung, sind aber komplexer in der Herstellung. Mit einer Vierfachschicht aus Brechschichten mit alternierend hohen und niedrigen Brechungsindizes kann beispielsweise die Bandbreite des reflektierten Lichts weiter reduziert werden bei verbesserter Transmission.

Im strukturierten Bereich der Deckplatte tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

In dem erfindungsgemäßen Fassadenelement gemäß dem ersten Aspekt der Erfindung ist mindestens eine Zone vorgesehen, in der die Segmente eine mittlere Rauigkeit von weniger als 15% der Schichtdicke der optischen Interferenzschicht auf der Außenfläche haben, wodurch eine konstruktive bzw. destruktive Interferenz des reflektierten Lichts ermöglicht ist. Für das erfindungsgemäße Fassadenelement gemäß dem zweiten Aspekt der Erfindung gilt eine analoge Bedingung für die Rauigkeit nur für die Segmente der strukturierten Innenfläche, auf welcher eine optische Interferenzschicht angeordnet ist. Vorteilhaft erstreckt sich diese Zone über die gesamte Deckplatte.

Gemäß einer Ausgestaltung der Erfindung weist der strukturierte Bereich mindestens eine weitere Zone, d.h. (Teil-)Bereich, auf, in dem die Segmente jeweils eine solche mittlere Rauigkeit aufweisen, dass eine Interferenz an der optischen Interferenzschicht nicht auftritt. Beispielsweise haben die Segmente dort eine mittlere Rauigkeit von 50% bis 100% der Schichtdicke der Interferenzschicht. In diesen Zonen weist das Fassadenelement keine durch die optische Interferenzschicht erzeugte Farbe auf.

Das opake Rückseitenelement ist mit der Deckplatte fest verbunden. Das Rückseitenelement kann selbst eine Farbe aufweisen, wobei die Farbe des Rückseitenelements die Gesamt-Farbe des Fassadenelements beeinflusst. Insbesondere kann die Farbe des Rückseitenelements in Entsprechung zum opaken Hintergrund farbiger Solarmodule gewählt sein, d.h. das Rückseitenelement kann eine Farbe aufweisen, die den optisch aktiven Solarzellen entspricht. Vorzugsweise ist das Rückseitenelement unbunt, dunkel und matt. Dann lassen sich der Farbeindruck und dessen Winkelabhängigkeit des passiven Fassadenelements besonders gut mit den entsprechend hergestellten farbigen Modulen auf Basis von Dünnschichtmodulen anpassen. Diese Eigenschaften lassen sich wie folgt beschreiben:
- ein L-Wert von maximal 50, bevorzugt kleiner 45 oder kleiner 40;
- ein Chroma c = (a²+b²)^{1/2} von maximal 5, bevorzugt kleiner 2 oder stärker bevorzugt kleiner 1,5.

Zur Vermeidung von Glanz kann zusätzlich folgende Anforderung hinzugenommen werden:
- ein Reflexions-Haze von mindestens 90% . Reflexionshaze ist der Anteil des diffus reflektierten Lichts an dem insgesamt reflektierten Licht.

Das Rückseitenelement ist beispielsweise in Form einer Beschichtung der Innenfläche der Deckplatte ausgebildet. Gleichermaßen kann das Rückseitenelement beispielsweise in Form eines mit der Innenfläche der Deckplatte fest verbundenen eigenständigen Körpers (keine Beschichtung), beispielsweise in Plattenform, ausgebildet sein. Der Körper kann ein tragender oder nicht-tragender Körper sein und kann als tragender Körper insbesondere eine Trägerplatte sein.

Gemäß besonders bevorzugten Ausgestaltungen des erfindungsgemäßen Fassadenelements ist das Rückseitenelement ausgebildet als:
- eine rückseitige Beschichtung der Deckplatte, oder
- eine opake Folie, die durch ein transparentes Klebemittel, insbesondere eine transparente Klebefolie, mit der Deckplatte fest verbunden ist, oder
- ein opaker starrer Körper, der durch ein transparentes Klebemittel, insbesondere eine transparente Klebefolie, mit der Deckplatte fest verbunden ist.

Die Erfindung bezieht sich weiterhin auf ein Verfahren zur Herstellung eines erfindungsgemäßen Fassadenelements gemäß dem ersten Aspekt der Erfindung, wie es vorstehend beschrieben ist.

Hierbei wird in einem ersten Verfahrensschritt a) eine ebene transparente Deckplatte bereitgestellt, die eine Außenfläche, welche der äußeren Umgebung zugewandt sein soll, und eine gegenüberliegende Innenfläche aufweist.

Anschließend wird aus den folgenden drei (alternativen) Verfahrensschritten ein einziger zweiter Verfahrensschritt b1), b2) oder b3) ausgewählt und durchgeführt:
b1) Strukturieren der Außenfläche mindestens in einem Bereich und Aufbringen einer optischen Interferenzschicht auf den strukturierten Bereich. In diesem Fall wird die Innenfläche nicht strukturiert und keine optische Interferenzschicht auf die Innenfläche aufgebracht.
b2) Strukturieren der Außenfläche mindestens in einem Bereich, Aufbringen einer optischen Interferenzschicht auf den strukturierten Bereich der Außenfläche und Aufbringen einer weiteren optischen Interferenzschicht auf die Innenfläche. In diesem Fall wird die Innenfläche nicht strukturiert.
b3) Strukturieren der Außenfläche mindestens in einem Bereich, Aufbringen einer optischen Interferenzschicht auf den strukturierten Bereich der Außenfläche, Strukturieren der Innenfläche mindestens in einem Bereich und Aufbringen einer weiteren optischen Interferenzschicht auf den strukturierten Bereich der Innenfläche.

Zudem wird in einem dritten Verfahrensschritt c) ein Rückseitenelement an der Innenfläche der Deckplatte angebracht. Falls der zweite Verfahrensschritt b1) durchgeführt wird, kann der dritte Verfahrensschritt c) auch vor dem zweiten Verfahrensschritt b1) durchgeführt werden. Ansonsten werden der erste, zweite und dritte Verfahrensschritt in der Reihenfolge a), b2) oder b3), c) durchgeführt.

Die Erfindung bezieht sich weiterhin auf ein Verfahren zur Herstellung eines erfindungsgemäßen Fassadenelements gemäß dem zweiten Aspekt der Erfindung, wie es vorstehend beschrieben ist.

Hierbei wird in einem ersten Verfahrensschritt a) eine ebene transparente Deckplatte bereitgestellt, die eine Außenfläche, welche der äußeren Umgebung zugewandt sein soll, und eine gegenüberliegende Innenfläche aufweist.

Anschließend wird aus den folgenden vier (alternativen) Verfahrensschritten ein einziger zweiter Verfahrensschritt b1), b2), b3) oder b4) ausgewählt und durchgeführt:
b1) Strukturieren der Außenfläche mindestens in einem Bereich und Aufbringen einer optischen Interferenzschicht auf die Innenfläche. In diesem Fall wird keine weitere optische Interferenzschicht auf die Außenfläche aufgebracht. Ferner wird die Innenfläche nicht strukturiert.
b2) Strukturieren der Außenfläche mindestens in einem Bereich, Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht.
b3) Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht. Ferner wird die Außenfläche nicht strukturiert.
b4) Strukturieren der Innenfläche mindestens in einem Bereich, Aufbringen einer optischen Interferenzschicht auf den strukturierten Bereich der Innenfläche und Aufbringen einer weiteren optischen Interferenzschicht auf die Außenfläche. In diesem Fall wird die Außenfläche nicht strukturiert.

Zudem wird in einem dritten Verfahrensschritt c) ein Rückseitenelement an der Innenfläche der Deckplatte angebracht. Der erste, zweite und dritte Verfahrensschritt werden in dieser Reihenfolge durchgeführt.

In obigen Verfahren umfasst das Strukturieren der Außenfläche bzw. Innenfläche auch das Aufbringen einer mit mindestens einem strukturierten Bereich versehenen, transparenten Schicht auf die Deckplatte, welche die Außenfläche bzw. Innenfläche bildet.

Des Weiteren erstreckt sich die Erfindung auf die Verwendung des erfindungsgemäßen Fassadenelements als (integraler) Bestandteil einer Gebäudehülle (Gebäudewand) oder einer freistehenden Wand, beispielsweise eine Sichtschutz- oder Lärmschutzwand, in Kombination mit als Fassadenelementen eingesetzten (fotovoltaisch aktiven) farbigen Solarmodulen, insbesondere jenen die in den eingangs genannten nicht-veröffentlichten europäischen Patentanmeldungen EP18186153.5 und EP18186161.8 beschrieben sind.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1-2: den Grundaufbau verschiedener Ausgestaltungen des erfindungsgemäßen Fassadenelements in schematischen Querschnittansichten;
- Fig. 3: eine schematische Querschnittansicht der Deckplatte einer Ausgestaltung des erfindungsgemäßen Fassadenelement;
- Fig. 4: eine schematische Darstellung typischer Lichtverhältnisse an einem erfindungsgemäßen Fassadenelement;
- Fig. 5-8: schematische Darstellungen beispielhafter Lichtwege bei Reflexion im strukturierten Bereich der Deckplatte von Figur 3;
- Fig. 9: eine schematische Darstellung der Interferenz von Lichtstrahlen in einer optischen Interferenzschicht;
- Fig. 10-11: weitere Ausgestaltungen der Deckplatte des erfindungsgemäßen Fassadenelements in schematischen Querschnittansichten;
- Fig. 12: schematische Darstellungen beispielhafter Lichtwege bei Reflexion an der Deckplatte im Fassadenelement von Figur 11;
- Fig. 13-14: weitere Ausgestaltungen der Deckplatte des erfindungsgemäßen Fassadenelements in schematischen Querschnittansichten;
- Fig. 15: eine schematische Darstellung beispielhafter Lichtwege bei Reflexion im strukturierten Bereich des Fassadenelements von Figur 14;
- Fig. 16: eine weitere Ausgestaltung der Deckplatte des erfindungsgemäßen Fassadenelements in einer schematischen Querschnittansicht;
- Fig. 17: eine schematische Darstellung beispielhafter Lichtwege bei Reflexion an der Deckplatte des Fassadenelements von Figur 16;
- Fig. 18-19: weitere Ausgestaltungen der Deckplatte des erfindungsgemäßen Fassadenelements in schematischen Querschnittansichten;
- Fig. 20-23: verschiedene beispielhafte Ausgestaltungen des Rückseitenelements des erfindungsgemäßen Fassadenelements;
- Fig. 24: ein Ablaufdiagramm zur Veranschaulichung des erfindungsgemäßen Verfahrens zur Herstellung eines Fassadenelements gemäß dem ersten Aspekt der Erfindung;
- Fig. 25: ein Ablaufdiagramm zur Veranschaulichung des erfindungsgemäßen Verfahrens zur Herstellung eines Fassadenelements gemäß dem zweiten Aspekt der Erfindung;
- Fig. 26: eine schematische Darstellung des Messverfahrens zur Mehrwinkel-Farbmessung.

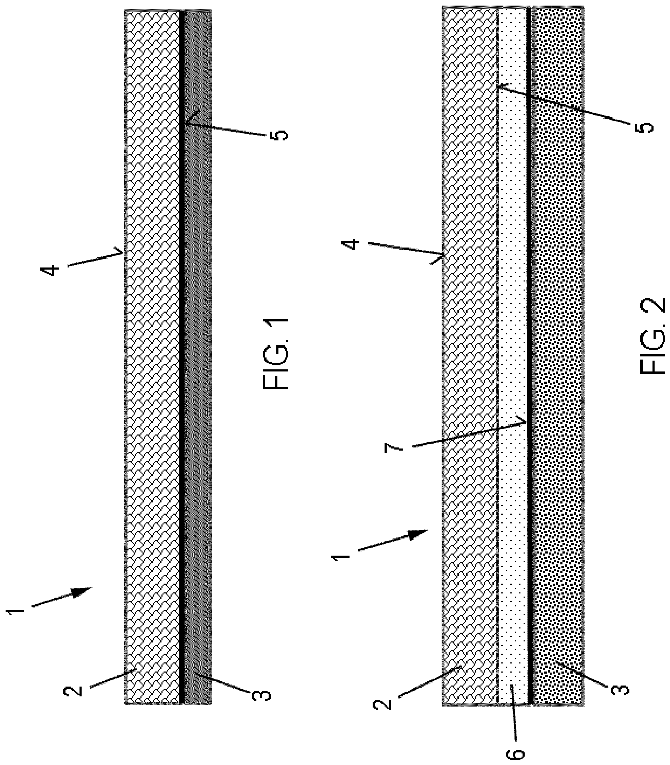

In Figur 1 ist der Aufbau eines insgesamt mit der Bezugszahl 1 bezeichneten Fassadenelements gemäß einem Ausführungsbeispiel vorliegender Erfindung in schematischer Weise anhand einer Querschnittansicht (Schnitt senkrecht zur Oberfläche des Fassadenelements) veranschaulicht. Das Fassadenelement 1 umfasst eine transparente Deckplatte 2 und ein opakes Rückseitenelement 3. Die Deckplatte 2 ist beispielsweise eine Glasscheibe und besteht aus einem Glas, das vorzugsweise eine geringe Absorption aufweist, wie zum Beispiel Kalknatronglas. Die Deckplatte 2 umfasst eine der äußeren Umgebung zugewandte Außenfläche 4 und eine dem Rückseitenelement 3 zugewandte Innenfläche 5. Möglich wäre auch, dass die Deckplatte 2 als Verbundkörper ausgebildet ist und insbesondere aus einem transparenten Kern besteht, der in ein anderes transparentes Material eingebettet ist (z.B. Sandwich-artig), welches den gleichen optischen Brechungsindex hat wie der Kern. Die Außenfläche 4 und Innenfläche 5 werden dann von diesem Material gebildet. Dies ist in Figur 1 nicht näher dargestellt. Das Rückseitenelement 3 ist hier beispielsweise in Form einer Beschichtung der Innenfläche 5 ausgebildet, welche sich über die komplette Innenfläche 5 erstreckt. Die Beschichtung kann aus einer oder mehreren Schichten bestehen. Als Beschichtung können beispielsweise Lacke, Polymerschichten, Polymerfolien oder anorganische Schichten aus Metalloxidpulvern, Kohlenstoff oder Halbleitermaterialien eingesetzt werden. Die Schichtdicke des Rückseitenelements 3 ist frei wählbar, solange die gewünschten optischen Eigenschaften der Beschichtung gewährleistet sind. Falls erforderlich, kann das Rückseitenelement 3 durch eine rückseitige Abdeckung, die beispielsweise in Form einer weiteren Beschichtung oder Folie ausgebildet ist, vor Umwelteinwirkungen geschützt werden. Das Rückseitenelement 3 ist nicht-tragend, so dass die Deckplatte 2 die spezifischen Anforderungen für die Nutzung als Fassadenelement 1 zu erfüllen hat. Insbesondere sind die mechanische Belastbarkeit und die Möglichkeit einer geeigneten Verbindung mit dem Baukörper sicherzustellen, beispielsweise durch die Verwendung von Rahmen, Klammern oder Rückseitenschienen. Zu diesem Zweck besteht die Deckplatte 2 vorzugsweise aus veredeltem Glas, wie beispielsweise thermisch gehärtetes Glas, so genanntes Einscheibensicherheits-glas(ESG), oder teilvorgespanntes Glas (TVG). Die Beschichtung ist opak und kann beispielsweise eine vorgebbare Farbe aufweisen, so dass durch die Hintergrundfarbe der Beschichtung in gewünschter Weise ein Gesamtfarbeindruck des Fassadenelemts erzeugt wird. Es ist gleichermaßen möglich, dass das Rückseitenelement zu diesem Zweck unbunt, dunkel und matt ist.

Es wird nun Bezug auf Figur 2 genommen, worin der Aufbau eines weiteren Ausführungsbeispiels des Fassadenelements 1 gemäß vorliegender Erfindung in schematischer Weise anhand einer Querschnittansicht veranschaulicht ist. Um unnötige Wiederholungen zu vermeiden, werden lediglich die Unterschiede zum Ausführungsbeispiel von Figur 1 erläutert und ansonsten wird auf obige Ausführungen Bezug genommen. Demnach ist das Rückseitenelement 3 keine Beschichtung sondern ein eigenständiger Körper mit definierter Raumform, der unabhängig von der Deckplatte 2 vorliegt und mit der Innenfläche 5 der Deckplatte 2 hier beispielsweise mittels einer transparenten Klebeschicht 6 (z.B. Laminierfolie) fest verbunden ist. Grundsätzlich kann jede geeignete Fügetechnik zur festen Verbindung von Deckplatte 2 und Rückseitenelement 3 eingesetzt werden, beispielsweise Kleben oder Vergießen. Vorteilhaft sind Fügeverfahren, bei denen das zum Fügen verwendete transparente Material (beispielsweise Klebeschicht, Laminierfolie oder Vergussmaterial) einen Brechungsindex von größer 1.4 und kleiner als 1.6 besitzt. Ansonsten kann gegebenenfalls die resultierende Farbe des Fassadenelements 1 in unerwünschter Weise geändert werden.

Das Rückseitenelement 3 ist hier beispielsweise in Form einer ebenen Platte ausgebildet, welche eine Kontaktfläche 7 zur festen Verbindung mit der Innenfläche 5 der Deckplatte 2 aufweist. Das Rückseitenelement 3 überdeckt die Innenfläche 5 vollständig. Die Deckplatte 2 und das plattenförmige Rückseitenelement 3 bilden einen Verbundkörper. Das hier als eigenständiger Körper ausgebildete Rückseitenelement 3 kann tragend oder nicht-tragend sein. Im vorliegenden Ausführungsbeispiel ist das plattenförmige Rückseitenelement 3 tragend (Trägerplatte) und weist zu diesem Zweck geeignete mechanische Eigenschaften auf, um durch sich selbst oder im Verbund mit der Deckplatte 2 die Tragfähigkeit des Fassadenelements 1 sicherzustellen. Das so erzeugte Fassadenelement kann in einfacher Weise mit dem Baukörper verbunden werden und muss insgesamt die Anforderungen als Fassadenelement in der Gebäudehülle erfüllen.

Das plattenförmige Rückseitenelement 3 besteht beispielsweise aus einem Faserverbundwerkstoff, Glas, Stein, Metall oder Keramik und kann insbesondere mit einer Farbe, beispielsweise eine keramische Siebdruckfarbe oder organische Glasfarbe oder einer geeigneten anorganischen Dünnschicht beschichtet sein, um eine gewünschte Hintergrundfarbe bereitzustellen. Möglich ist auch, dass das Material des Rückseitenelements 3 selbst bereits eine gewünschte Farbe aufweist. Beispielsweise besteht das Rückseitenelement 3 aus einem in der Glasmatrix gefärbten Glas. Möglich ist auch die Verwendung von CIGS-Dünnschichten, die als Abfall aus der Serienproduktion entstanden sind, um einen besonders homogenen Farbeindruck einer Fassade in Kombination mit CIGS-Dünnschichtsolarmodulen zu erzielen. Ein gläsernes Rückseitenelement 3 kann in einfacher Weise mit herkömmlichen Laminierungsverfahren mit einer gläsernen Deckplatte 2 verbunden werden. Beispielsweise ist das Rückseitenelement 3 ein Metallblech, eine Metallfolie oder besteht aus einem Metallverbundmaterial. Das Metallblech oder die Metallfolie können beispielsweise durch Eloxieren oder Beschichten so behandelt werden, dass die gewünschten optischen Eigenschaften entstehen. Das Rückseitenelement 3 kann gleichermaßen aus für den Außenbereich geeigneten Baumaterialien bestehen, beispielsweise Faserzementplatten, Betonplatten, textilbewehrte oder faserverstärke Betonschalen, Holz/Holzfaserwerkstoffe, Kunststoffe oder andere nichtmetallische Verbundmaterialien. Die Oberfläche des Materials kann mit dem verwendeten Material entsprechenden Farbgebungstechnologien so gestaltet werden, dass sich die gewünschten optischen Eigenschaften ergeben.

Je nach Ausgestaltung des Fassadenelements 1 ist die Außenfläche 4 und/oder die Innenfläche 5 der Deckplatte 2 strukturiert (z.B. durch Ätzung, Sandstrahlen oder Walzen beim Ziehprozess) und weist mindestens eine optische Interferenzschicht auf, was in Figur 1 und Figur 2 nicht dargestellt ist. Dies wird im Weiteren näher erläutert.

Der Aufbau des Fassadenelements 1 von Figur 1 oder Figur 2 kann gleichermaßen in Fassadenelementen gemäß dem ersten Aspekt und zweiten Aspekt der Erfindung eingesetzt werden.

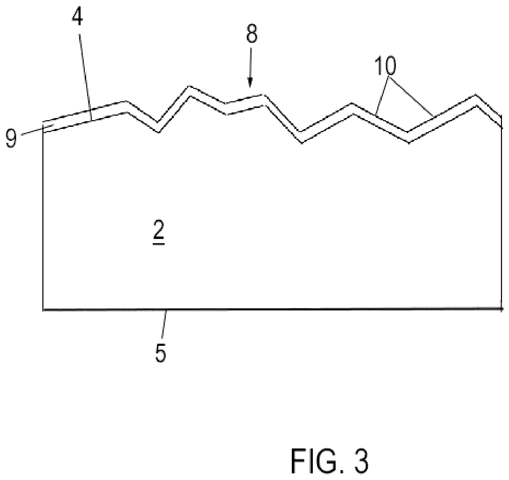

In Figur 3 ist eine Ausgestaltung des erfindungsgemäßen Fassadenelements 1 gemäß dem ersten Aspekt der Erfindung veranschaulicht, wobei lediglich die Deckplatte 2 mit einer beispielhaften Strukturierung gezeigt ist. Das Fassadenelement kann insbesondere wie in Figur 1 oder Figur 2 ausgebildet sein. Demnach ist die Außenfläche 4 der Deckplatte 2 in einem Bereich 8 strukturiert, welcher sich im vorliegenden Beispiel über die komplette Außenfläche 4 erstreckt, d.h. Außenfläche 4 und strukturierter Bereich 8 sind identisch. Unmittelbar auf der Außenfläche 4 ist eine optische Interferenzschicht 9 angeordnet. Im strukturierten Bereich 8 ist die Außenfläche 4 mit einem Höhenprofil versehen, das Berge und Täler aufweist. Hierbei bestehen mehr als 50% der Außenfläche 4 aus ebenen Segmenten 10, deren Ebenen jeweils zur Ebene der Deckplatte 2 geneigt sind, d.h. einen von Null verschiedenen Winkel zur Ebene der Deckplatte 2 aufweisen. Die Segmente 10 haben jeweils eine Segmentfläche von mindestens 1 µm² und eine mittlere Rauigkeit von weniger als 15% der Schichtdicke d der optischen Interferenzschicht 9. Ein mittlerer Höhenunterschicht zwischen den höchsten Punkten (Berge) und niedrigsten Punkten (Täler) der Außenfläche 4 beträgt mindestens 2 µm und beispielsweise maximal 20% der Dicke der Deckplatte 2. Bezogen auf die Ebene der Deckplatte 2 haben mindestens 20% der Segmente einen Neigungswinkel im Bereich von größer als 0° bis maximal 15°, mindestens 30% der Segmente einen Neigungswinkel im Bereich von größer als 15° bis maximal 45° und weniger als 30% der Segmente 10 einen Neigungswinkel von größer als 45°. Im Ausführungsbeispiel von Figur 3 haben alle Segmente einen Neigungswinkel von maximal 45°.

Die optische Interferenzschicht 9 ist dünn und weist eine Schichtdicke beispielsweise im Bereich von 0,1 bis einige (z.B. 2) Mikrometer auf. Ferner hat die optische Interferenzschicht 9 einen Brechungsindex n von größer als 1,7, vorzugsweise größer als 2,0 und besonders bevorzugt größer als 2,3, sowie eine möglichst geringe Absorption in Bezug auf das einfallende Licht. Die optische Interferenzschicht 9 kann ein- oder mehrlagig ausgebildet sein, d.h. aus einer oder mehreren Brechungsschichten bestehen. Jede Brechungsschicht weist einen bestimmten Brechungsindex auf und besteht aus demselben Material. Beispielsweise besteht die optische Interferenzschicht 9 aus MgO, SiONx, Si₃N₄, ZrO₂, TiOx und/oder SiC. Die elektrische Leitfähigkeit der einzelnen Brechungsschichten, insbesondere der optischen Interferenzschicht 9, sollte möglichst gering sein.

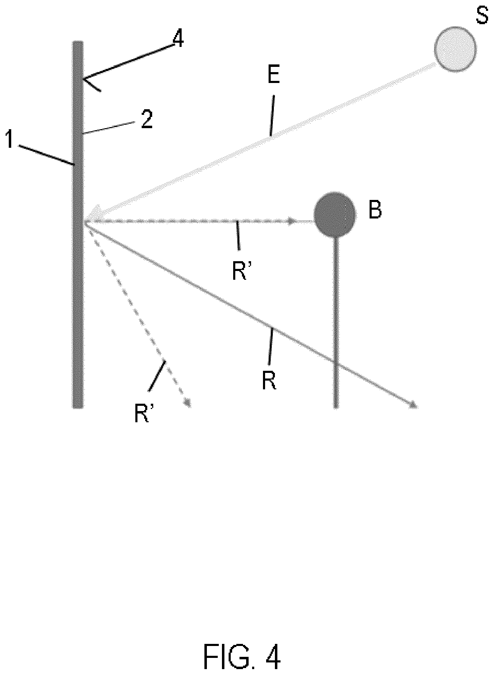

Im Weiteren wird die Funktionsweise der Strukturierung der Außenfläche 4 der Deckplatte 2 näher beschrieben. Sei zunächst Figur 4 betrachtet, worin beispielhaft typische Lichtverhältnisse bei einem Fassadenelement 1 veranschaulicht sind. Demnach trifft Licht von der Sonne S direkt auf die Deckplatte 2 und wird im Glanzwinkel reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut. Zwei diffus gestreute Lichtstrahlen R' sind beispielhaft gezeigt. Der Farbeffekt entsteht durch Reflexion, Streuung und Interferenz. Steht ein Beobachter B vor dem Fassadenelement 1 und blickt senkrecht auf die Deckplatte 2 vor ihm, trifft sein Auge nur in den seltensten Fällen das direkt reflektierte Licht R (d.h. der Beobachter steht meist nicht im Glanzwinkel). Dies ist in Figur 4 veranschaulicht, wo sich der Beobachter B außerhalb des Glanzwinkels befindet und nur den diffus gestreuten Lichtstrahl R' sieht. Bei einer glatten Oberfläche ohne strukturierten Bereich 8 ist die Intensität des diffus gestreuten Lichts R' relativ gering und weist eine starke Winkelabhängigkeit auf. Erst wenn der diffus gestreute Anteil ausreichend groß ist, gibt es eine deutliche Farbe mit zufriedenstellender Intensität (Helligkeit, L-Wert).

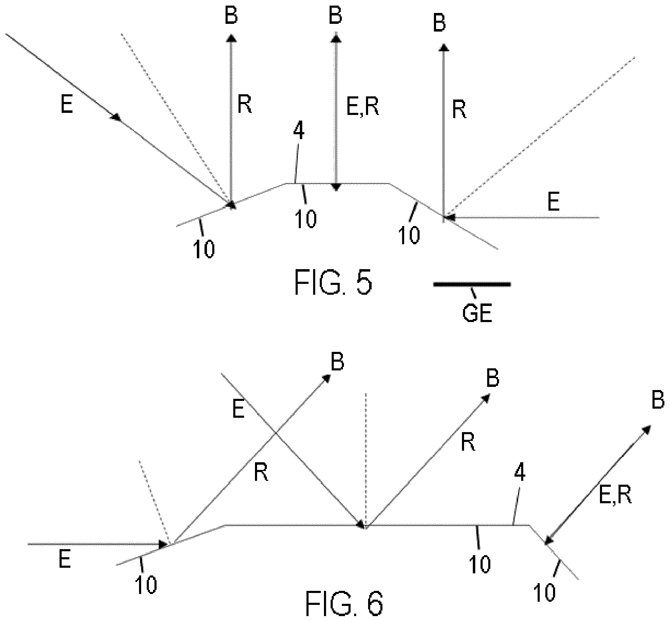

Das Grundprinzip der Wirkungsweise der geneigten Segmente 10 des strukturierten Bereichs 8 ist in Figur 5 veranschaulicht, worin beispielhaft die verschiedenen Lichtwege für einen Beobachter B gezeigt sind, der senkrecht auf die Glasoberfläche bzw. Außenfläche 4 des Fassadenelements 1 blickt. Gezeigt sind drei Segmente 10 mit verschiedenen Neigungen zur schematisch veranschaulichten Ebene GE der Deckplatte 2, sowie die auf die Segmente 10 treffenden Lichtstrahlen E, die von den Segmenten 10 jeweils im lokalen Glanzwinkel zum Beobachter B reflektiert werden (reflektierte Lichtstrahlen R). Das mittlere Segment 10 ist parallel zur Ebene GE angeordnet, wobei der einfallende Lichtstrahl E senkrecht auf das Segment 10 trifft und senkrecht zum Beobachter B reflektiert wird (reflektierter Strahl R). Für das mittlere Segment 10 sind Glanzwinkel und lokaler Glanzwinkel identisch. Bei den beiden angrenzenden Segmenten 10 haben die einfallenden Lichtstrahlen E jeweils einen von Null verschiedenen Winkel zur Oberflächennormalen auf die Ebene GE und treffen ebenfalls im lokalen Glanzwinkel auf den Beobachter B. Aufgrund der unterschiedlichen Neigungen der Segmente 10 wird Licht aus verschiedenen Richtungen jeweils im lokalen Glanzwinkel der Segmente 10 zu dem senkrecht auf die Modulfläche blickenden Beobachter B reflektiert. Im Ausführungsbeispiel von Figur 5 betragen Ein- und Ausfallswinkel maximal 45°.

In Figur 6 ist eine Situation gezeigt, bei der der Beobachter B in einem Winkel von 45° zur Oberflächennormalen auf die Ebene GE der Deckplatte 2 sieht. Wie in Figur 5 sind beispielhaft drei Segmente 10 mit verschiedenen Neigungen zur Ebene GE der Deckplatte 2 gezeigt, sowie die jeweils auf die Segmente 10 treffenden Lichtstrahlen E, die von den Segmenten 10 im lokalen Glanzwinkel zum Beobachter B reflektiert werden (reflektierte Lichtstrahlen R). Aufgrund der unterschiedlichen Neigungen der Segmente 10 wird Licht aus verschiedenen Richtungen jeweils im lokalen Glanzwinkel zu dem auf die Modulfläche blickenden Beobachter B reflektiert. Im Ausführungsbeispiel von Figur 6 betragen Ein- und Ausfallswinkel maximal 67,5°. Grundsätzlich gilt, dass bei relativ großen Werten des Glanzwinkels das reflektierte Licht blauverschoben ist. Diese Blauverschiebung kann durch einen höheren Brechungsindex der optischen Interferenzschicht reduziert werden. Bei relativ steilen Flächenneigungen kann es auch zur Mehrfach-Reflexion an benachbarten Facetten kommen.

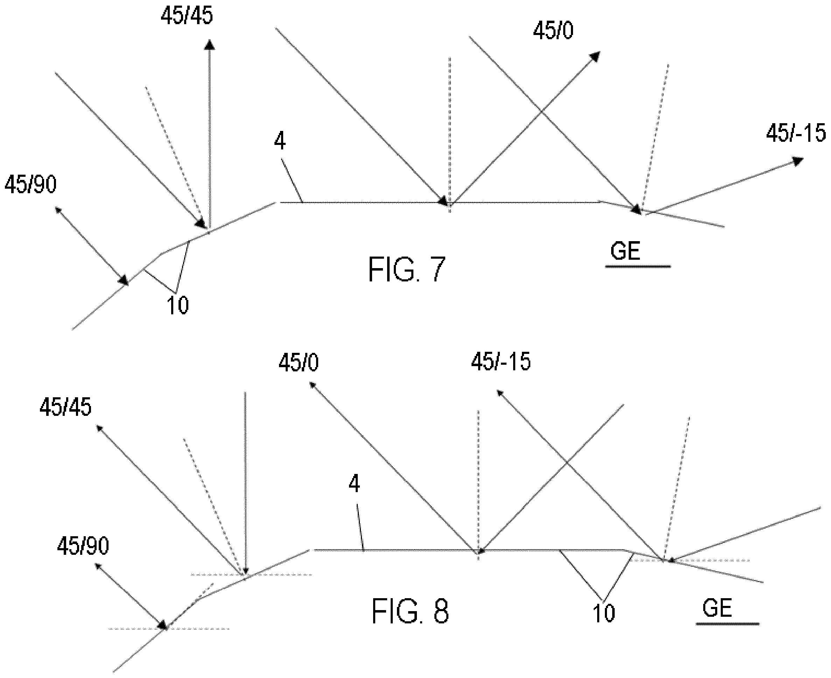

In Figur 7 ist eine Situation gezeigt, bei der die Lichtquelle und dementsprechend die einfallenden Lichtstrahlen stets in einem Winkel von 45° zur Ebene GE der Deckplatte 2 geneigt sind. Der Beobachter B betrachtet die Oberfläche des Fassadenelements 1 unter verschiedenen Winkeln. Die Winkelangaben in Figur 7 sind wie folgt zu verstehen: Einfallswinkel (bezogen auf Ebene GE der Deckplatte 2) / Beobachtungs- bzw. Reflexionswinkel (Abweichung vom Glanzwinkel bezogen auf Oberflächennormale auf Ebene GE). Das Gradzeichen "°" ist nicht angegeben. In Figur 7 sind beispielhaft vier Segmente 10 mit verschiedenen Neigungen zur Ebene GE gezeigt. Lediglich in einem Segment 10, dessen Ebene parallel zur Ebene der Deckplatte 2 ist, befindet sich der Beobachter B im Glanzwinkel in Bezug auf die Ebene GE: 45/0. Dies bedeutet, dass der einfallende Lichtstrahl einen Winkel von 45° zur Ebene GE hat, der reflektierte Lichtstrahl eine Winkelabweichung Null vom Glanzwinkel. Bei den anderen Segmenten 10 befindet sich der Beobachter B außerhalb des Glanzwinkels. Bei den beiden linken Segmenten 10 (45/90, 45/45) betrachtet der Beobachter die Oberfläche des Fassadenelements 1 in einem Winkel von 90° bzw. 45° zum Glanzwinkel, wobei das Licht in einem Winkel von 45° zur Ebene GE einfällt. Beim rechten Segment 17 (45/-15) befindet sich der Beobachter in einem Winkel von -15° zum Glanzwinkel. Aufgrund der verschieden geneigten Segmente 10 und der hierdurch bedingten Reflexion im lokalen Glanzwinkel wird auch dann Licht mit hinreichender Intensität zum Beobachter B reflektiert, wenn sich der Beobachter nicht im Glanzwinkel, bezogen auf die Ebene GE der Deckplatte 10, befindet.

In Figur 8 ist eine Situation gezeigt, bei der der Beobachter B die Oberfläche des Fassadenelements 1 stets in einem Winkel von 45° zur Moduloberfläche bzw. Ebene GE der Deckplatte 2 beobachtet. In Figur 8 sind beispielhaft vier Segmente 10 mit verschiedenen Neigungen zur Ebene GE gezeigt. Lediglich in einem Segment 10, dessen Ebene parallel zur Ebene GE ist, befindet sich der Beobachter B im Glanzwinkel: 45/0. Bei den anderen Segmenten 10 befindet sich der Beobachter B außerhalb des Glanzwinkels. Bei den beiden linken Segmenten 10 (45/90, 45/45) betrachtet der Beobachter B die Oberfläche des Fassadenelements 1 in einem Winkel von 45°, wobei das Licht in einer Abweichung von 90° bzw. 45° relativ zum Glanzwinkel einfällt. Beim rechten Segment 10 (45/-15) fällt das Licht in einem Winkel von -15° zum Glanzwinkel ein. Aufgrund der verschieden geneigten Segmente 10 und der hierdurch bedingten Reflexion im lokalen Glanzwinkel wird auch dann Licht mit hinreichender Intensität zum Beobachter B reflektiert, wenn Licht außerhalb des Glanzwinkels einfällt.

In dem erfindungsgemäßen Fassadenelement 1 kann durch die Strukturierung der Außenfläche 4 der Deckplatte 2 in Kombination mit der farbgebenden optischen Interferenzschicht 9 ein homogener Farbeeindruck in einem vorgebbaren Wellenlängenbereich erreicht werden, wobei der Farbeindruck im Vergleich zu einer nichtstrukturierten Oberfläche weitaus weniger winkelabhängig ist.

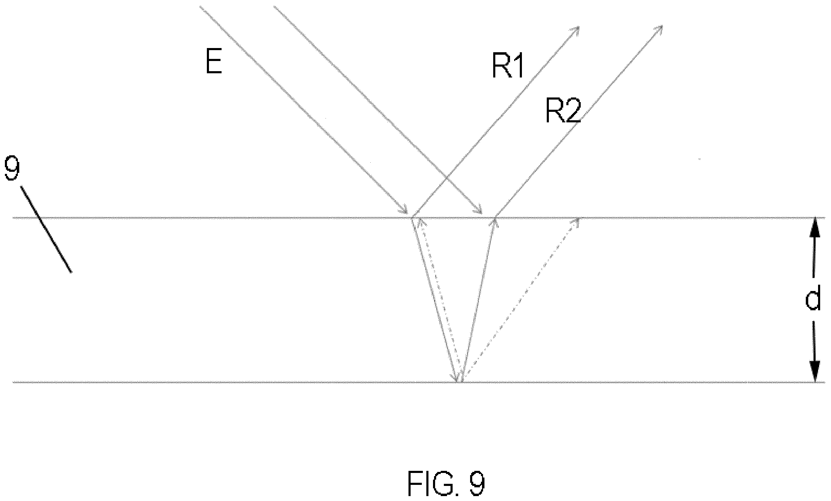

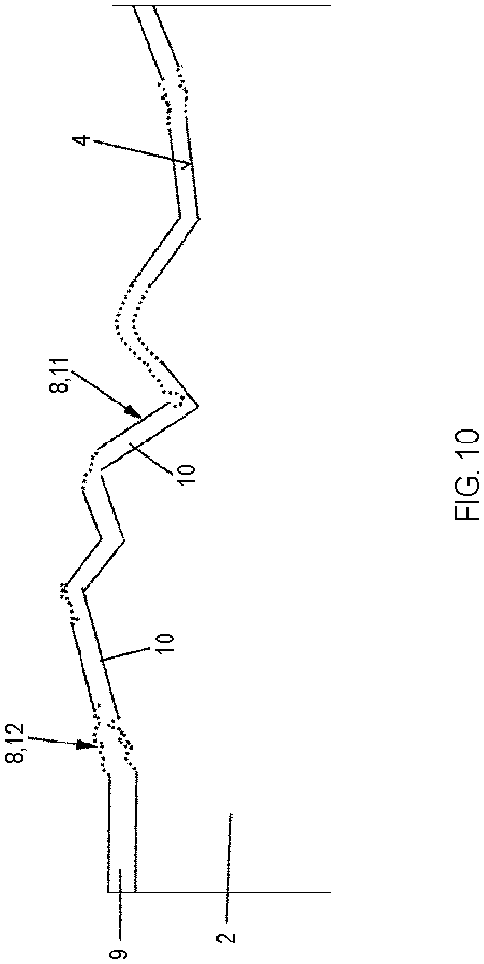

In Figur 9 ist die Reflexion an der optischen Interferenzschicht 9 mit Schichtdicke d veranschaulicht. Der einfallende Lichtstrahl E wird sowohl an der Grenzfläche Atmosphäre-Interferenzschicht (R1) als auch an der Grenzfläche Interferenzschicht-Deckplatte (R2) reflektiert. Falls der Gangunterschied der beiden Lichtstrahlen R1, R2 einem Vielfachen der Wellenlänge des einfallenden Lichtstrahls entspricht, tritt konstruktive Interferenz auf, bei einem Gangunterschied von einem Vielfachen der halben Wellenlänge destruktive Interferenz. Bei Beleuchtung mit weißem Licht wirkt die optische Interferenzschicht 9 somit als Farbfilter, da konstruktive Interferenz, abhängig vom Brechungsindex n und Schichtdicke d, nur für Licht geeigneter Wellenlänge auftritt. Hierbei ist α der Winkel der reflektierten Strahlen R1, R2, zur Oberflächennormalen. Die Lichtstrahlen R' veranschaulichen beispielhaft das reflektierte Licht außerhalb des Glanzwinkels, welche im strukturierten Bereichs 15 auftreten können, wenn die Rauigkeit der Grenzfläche zwischen Interferenzschicht-Deckplatte zu groß ist. Um die Interferenzbedingung zu erfüllen, ist es erforderlich, dass die Streuzentren jeweils kleiner als Wellenlänge und Schichtdicke sind. Dies kann durch die erfindungsgemäß beanspruchte Minimalfläche der Segmente und deren maximale Rauigkeit erreicht werden. Dieser Effekt wird gemäß einer Ausgestaltung der Erfindung ausgenutzt (siehe Figur 10).

Falls die Außenfläche 4 der Deckplatte 2 mit einer optischen Interferenzschicht 9, bestehend aus einer anorganischen, chemisch inerten und harten Schicht wie zum Beispiel mit Si₃N₄, beschichtet ist, ergibt sich eine hohe Kratzfestigkeit, chemische Beständigkeit und schmutzabweisende Wirkung für das Fassadenelement 1. Durch die Verwendung von fotokatalytischen Schichten wie TiO₂ kann sich zudem ein selbstreinigender Effekt ergeben. Klimatests haben auch ergeben, dass Interferenzschichten aus Materialen wie Si₃N₄ oder TiO₂ auch die Korrosion einer gläsernen Deckplatte durch feuchte Hitze unterbinden.

Es wird nun Bezug auf Figur 10 genommen, worin eine weitere Ausgestaltung des erfindungsgemäßen Fassadenelements 1 gemäß dem ersten Aspekt der Erfindung veranschaulicht ist, wobei lediglich die Deckplatte 2 gezeigt ist. Um unnötige Wiederholungen zu vermeiden, werden nur die Unterschiede zur Ausgestaltung von Figur 3 beschrieben und ansonsten wird auf obige Ausführungen Bezug genommen. Bei dieser Ausgestaltung weist der strukturierte Bereich 8 der Außenfläche 4 erste Zonen 11 und zweite Zonen 12 auf. Hierbei sind die ersten Zonen 11 so ausgebildet, dass die Segmente 10 eine mittlere Rauigkeit haben, die weniger als 15% der Schichtdicke d der optischen Interferenzschicht 9 auf der Außenfläche 4 beträgt. In der Ausgestaltung von Figur 3 gilt dies für den gesamten strukturierten Bereich 8. Im Unterschied hierzu ist die mittlere Rauigkeit in den zweiten Zonen 12 so groß, dass eine Interferenz in der optischen Interferenzschicht 9 unterbunden wird. Beispielsweise beträgt die mittlere Rauigkeit der Segmente 10 in den zweiten Zonen 12 mehr als 50% der Schichtdicke der optischen Interferenzschicht 9. Das Fassadenelement 1 hat deshalb in den ersten Zonen 11 eine homogene Farbe, welche sich aus der Farbfilterwirkung der optischen Interferenzschicht 9 ergibt. In den zweiten Zonen 12 hat die optische Interferenzschicht 9 durch fehlende konstruktive Interferenz keinen Farbfiltereffekt und es somit liegt im Wesentlichen eine Oberfläche vor, die dem Fassadenelement ohne optischer Interferenzschicht 9 entspricht. Das Fassadenelement 1 kann somit wahlfrei in den vorgebbaren ersten Zonen 11 mit einer homogenen Farbe versehen werden. In Figur 10 sind die zweiten Zonen 12 durch eine größere Rauigkeit schematisch veranschaulicht.

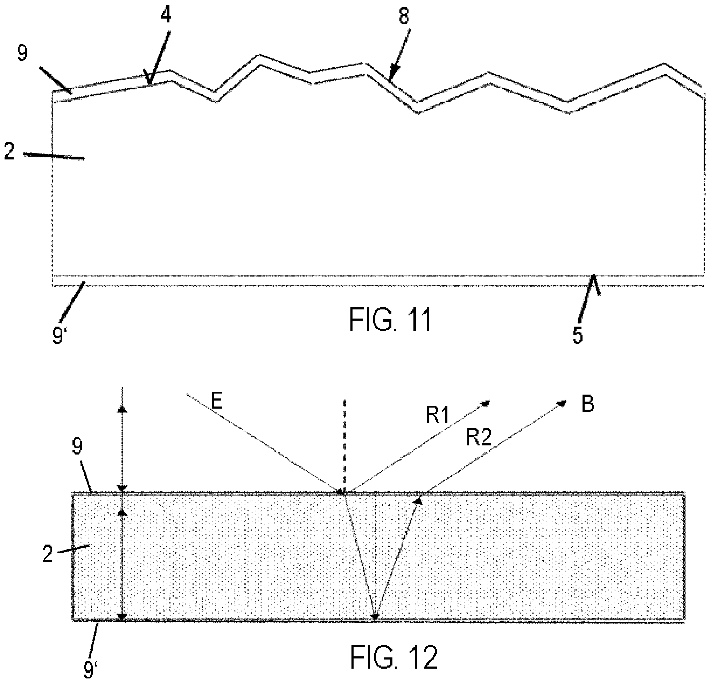

In Figur 11 ist eine weitere Ausgestaltung des erfindungsgemäßen Fassadenelements 1 gemäß dem ersten Aspekt der Erfindung veranschaulicht, wobei lediglich die Deckplatte 2 gezeigt ist. Um unnötige Wiederholungen zu vermeiden, werden lediglich die Unterschiede zur Ausgestaltung von Figur 3 beschrieben und ansonsten wird auf obige Ausführungen Bezug genommen. Demnach weist das Fassadenelement 1 auf der Außenfläche 4 der Deckplatte 2 auf dem strukturierten Bereich 8 eine erste optische Interferenzschicht 9 sowie auf der Innenfläche 5 der Deckplatte 2 eine zweite optische Interferenzschicht 9' auf. Die Innenfläche 5 der Deckplatte 2 ist nicht strukturiert, d.h. weist keinen strukturierten Bereich 8 analog zur Außenfläche 4 auf. Die Innenfläche 5 ist glatt im Rahmen der Produktionsungenauigkeiten. Die zweite optische Interferenzschicht 9' hat eine Schichtdicke d' und einen optischen Brechungsindex n', die gleich zu jenen der ersten optischen Interferenzschicht 9 sein können, jedoch nicht notwendigerweise gleich sein müssen. Durch die zweite optische Interferenzschicht 9' wird die Farbwirkung noch verstärkt. In Bezug auf die Ausgestaltung von Figur 3 gibt es hierdurch eine zweite Reflexionsquelle mit Farbfilterwirkung, da der Brechungsindex der zweiten optischen Interferenzschicht 9' zwischen der Deckplatte 2 (z.B. Glas) und der Klebeschicht 6 größer ist als jener von Deckplatte 2 (z.B. Glas) und Klebeschicht 6. Durch die Lichtbrechung ist der Eintrittswinkel bei der zweiten Reflexion geringer. Da das Licht in Summe dreimal eine optische Interferenzschicht passiert, ist das Licht, das den Beobachter erreicht, stärker gefiltert. Insbesondere können die Schichtdicken d, d' und die Brechungsindizes n, n' der beiden optischen Interferenzschichten 9, 9' auch voneinander deutlich verschieden sein. Bei Beschichtung mit deutlich unterschiedlichen optischen Dicken n*d bzw. n'* d' können Mischfarben generiert werden, da die erste optischen Interferenzschicht 9 dann ein anderes Reflexionsspektrum erzeugt als die zweite Interferenzschicht 9' und sich das von der zweiten Interferenzschicht 9' reflektierte Licht bei erneutem Passieren der erste Interferenzschicht 9 überlagert. So können auf sehr einfache und kostengünstige Weise farbige Fassadenelemente mit einer Vielfalt von Farben und hoher Winkelstabilität erzeugt werden.

In Figur 12 ist der Strahlengang des einfallenden Lichts E und reflektierten Lichts R1, R2 stark vereinfacht veranschaulicht. In Figur 12 ist die Strukturierung der Deckplatte 2 nicht gezeigt. Dargestellt ist nur ein einziger Strahlengang, hier im Glanzwinkel bezogen auf die Ebene der Deckplatte. Man erkennt, dass das Licht, das die erste Interferenzschicht 9 passiert hat, in der Deckplatte 9 (z.B. Glas) gebrochen wird, ein zweites Mal an der zweiten Interferenzschicht 9' reflektiert wird und dabei durch Interferenz gefiltert wird. Beim Austritt aus der Deckplatte 2 passiert es die Interferenzschicht 9, so dass Interferenzschichten dreimal passiert werden.

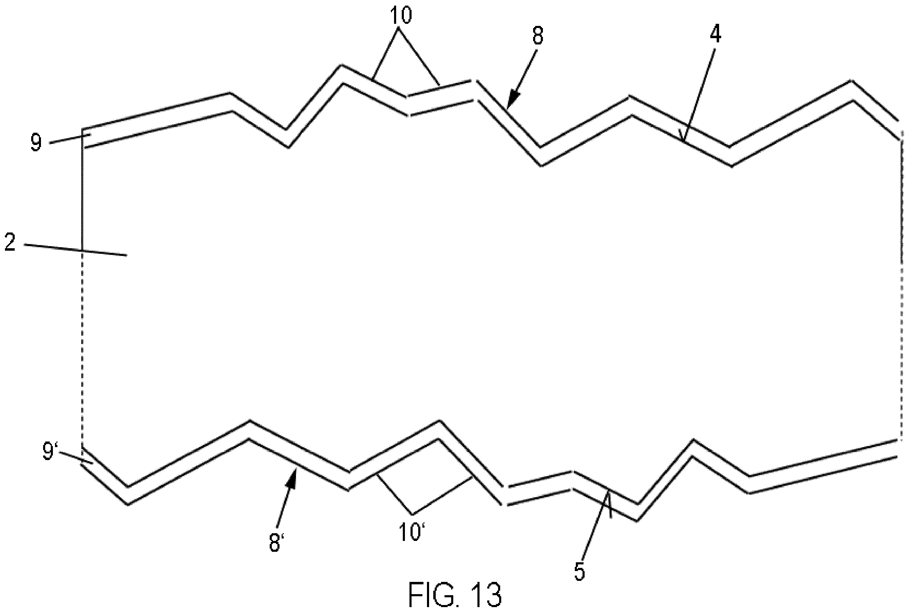

In Figur 13 ist eine weitere Ausgestaltung des erfindungsgemäßen Fassadenelements 1 gemäß dem ersten Aspekt der Erfindung veranschaulicht, wobei lediglich die Deckplatte 2 gezeigt ist. Um unnötige Wiederholungen zu vermeiden, werden lediglich die Unterschiede zur Ausgestaltung von Figur 11 beschrieben und ansonsten wird auf obige Ausführungen Bezug genommen. Demnach weist das Fassadenelement 1 auf der Außenfläche 4 der Deckplatte 2 einen ersten strukturierten Bereich 8 und auf der Innenfläche 5 der Deckplatte 2 einen zweiten strukturierten Bereich 8' auf, wobei auf dem ersten strukturierten Bereich 8 eine erste optische Interferenzschicht 9 und auf dem zweiten strukturierten Bereich 8' eine zweite optische Interferenzschicht 9' angeordnet ist. Die beiden strukturierten Bereiche 8, 8' können gleich oder verschieden ausgebildet sein. Ebenso können die beiden optischen Interferenzschichten 9, 9' gleich oder verschieden ausgebildet sein, wobei insbesondere die Schichtdicken d, d' und die Brechungsindizes n, n' der beiden optischen Interferenzschichten 9, 9' voneinander verschieden sein können. Wenn eine gleiche optische Dicke n*d für die beiden optischen Interferenzschichten 9, 9' gewählt wird, kann die Farbe des Fassadenelements 1 verstärkt werden. Bei Beschichtung mit deutlich unterschiedlichen optischen Dicken können Mischfarben generiert werden.

Allen oben beschriebenen Ausgestaltungen gemäß dem ersten Aspekt der Erfindung in den Figuren 3, 11 und 12 ist gemeinsam, dass bereits beim Auftreffen des Lichts auf die strukturierte Außenfläche mit Interferenzschicht durch Reflexion und Interferenz eine Farbe mit hohen Intensität und geringer Winkelabhängigkeit auch außerhalb des Glanzwinkels entsteht. Die zusätzlichen Interferenzschichten und/oder Strukturierungen der Ausgestaltungen in den Figuren 11 und 12 auf der Innenfläche können diese Wirkung noch verstärken.

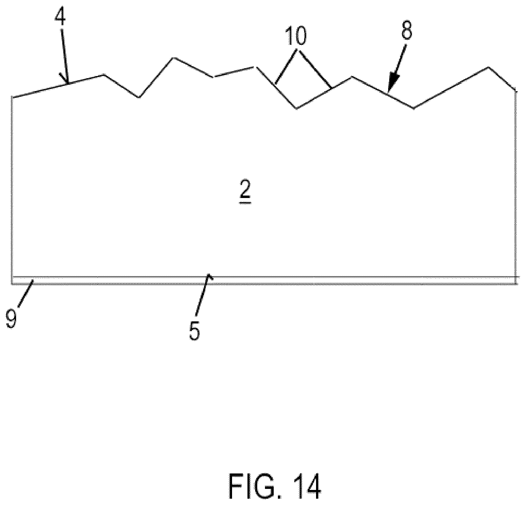

In Figur 14 ist anhand eines vergrößerten Ausschnitts der Deckplatte 2 des Fassadenelements 1 eine Ausgestaltung des erfindungsgemäßen Fassadenelements 1 gemäß dem zweiten Aspekt der Erfindung veranschaulicht. Um unnötige Wiederholungen zu vermeiden, werden lediglich die Unterschiede zur Ausgestaltung von Figur 3 beschrieben und ansonsten wird auf obige Ausführungen Bezug genommen. Demnach ist die Außenfläche 4 der Deckplatte 2 in einem Bereich 8 strukturiert, welcher sich im vorliegenden Beispiel über die komplette Außenfläche 4 erstreckt, d.h. Außenfläche 4 und strukturierter Bereich 8 sind identisch. Unmittelbar auf der Innenfläche 5 der Deckplatte 2 ist eine optische Interferenzschicht 9 angeordnet. Die Innenfläche 5 weist keine Strukturierung auf und ist im Rahmen der Produktionsungenauigkeiten glatt. Auf der Außenfläche 4 befindet sich keine optische Interferenzschicht. Für die Segmente 10 des strukturierten Bereichs 8 der Außenfläche 4 des Fassadenelements 1 von Figur 14 gibt es keine Bedingung für die Rauigkeit.

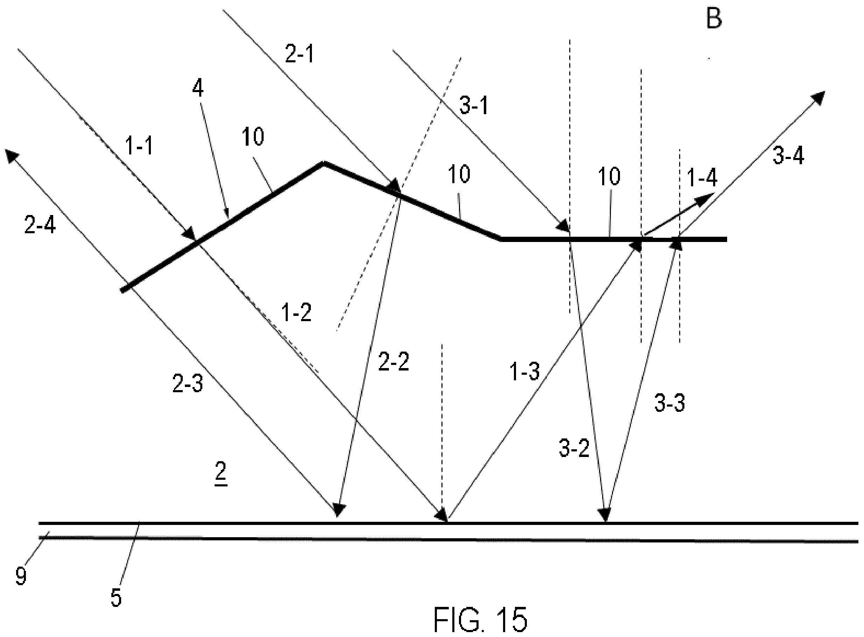

Anhand von Figur 15 wird die Funktion der strukturierten Außenfläche 4 in Kombination mit der innenseitigen Interferenzschicht 9 gemäß der Ausgestaltung von Figur 14 näher erläutert. Darin gezeigt sind beispielhaft verschiedene Lichtwege für verschieden geneigte Segmente 10 der Deckplatte 2. Beispielhaft sind drei Segmente 10 gezeigt, wobei das rechte Segment 10 parallel zur Ebene der Deckplatte 2 liegt und die beiden anderen Segmente 10 einen von Null verschiedenen Winkel zur Ebene der Deckplatte 2 haben. Die Reflexion der Lichtstrahlen an der Interferenzschicht 9 ist vereinfacht dargestellt. Die Reflexion an der Interferenzschicht 9 ist im Zusammenhang mit Figur 6 erläutert. In Figur 15 sind die Lichtwege für drei Lichtstrahlen gezeigt, die jeweils in einem selben Winkel zur Normalen der Ebene der Deckplatte 2 auf die verschieden geneigten Segmente 10 der Außenfläche 4 der Deckplatte 2 treffen. Das jeweilige Lot auf die Segmente 10 ist gestrichelt eingezeichnet. Aufgrund der verschieden geneigten Segmente 10 werden die Lichtstrahlen in verschiedener Weise reflektiert. Ein erster Lichtstrahl 1-1 trifft auf ein Segment 10, quert als gebrochener Lichtstrahl 1-2 die Deckplatte 2, wird als Lichtstrahl 1-3 von der Interferenzschicht 9 (im Glanzwinkel) reflektiert, und tritt als gebrochener Lichtstrahl 1-4 von der Deckplatte 2 zur äußeren Umgebung hin aus. Der letztlich von der Deckplatte 2 reflektierte Lichtstrahl 1-4 weist einen anderen Winkel zur Normalen auf die Ebene der Deckplatte 2 auf als der einfallende Lichtstrahl 1-1, so dass keine Reflexion im Glanzwinkel sondern Streuung vorliegt. In entsprechender Weise trifft ein zweiter Lichtstrahl 2-1 auf ein anderes Segment 10, quert als gebrochener Lichtstrahl 2-2 die Deckplatte 2, wird als Lichtstrahl 2-3 von der Interferenzschicht 9 reflektiert, und tritt als gebrochener Lichtstrahl 2-4 von der Deckplatte 2 zur äußeren Umgebung hin aus. Der reflektierte Lichtstrahl 2-4 tritt annähernd entgegen der Einfallsrichtung des Lichtstrahls 2-1 von der Deckplatte 2 aus, was ebenfalls ein Streuvorgang und keine Reflexion im Glanzwinkel ist. Ein dritter Lichtstrahl 3-1 trifft auf ein weiteres Segment 10, quert als gebrochener Lichtstrahl 3-2 die Deckplatte 2, wird als Lichtstrahl 3-3 von der Interferenzschicht 9 reflektiert, und tritt als gebrochener Lichtstrahl 3-4 von der Deckplatte 2 zur äußeren Umgebung hin aus. Dieses Segment 10 liegt parallel zur Ebene der Deckplatte 2, so dass der Lichtstrahl 2-4 im Glanzwinkel reflektiert wird. Wesentlich hierbei ist, dass durch jene Segmente 10, die zur Ebene der Deckplatte 2 geneigt sind, aufgrund der Brechung am jeweiligen Segment 10 und anschließende Reflexion an der Grenzfläche mit Interferenzschicht 9 und weiterer Brechung an der strukturierten Oberfläche insgesamt eine starke Reflexion auch außerhalb des Glanzwinkels (bezogen auf die Ebene der Deckplatte 2) auftritt, so dass in Kombination mit der Interferenzschicht 9 eine homogene Farbwirkung des reflektierten Lichts erreicht wird. In Figur 15 ist beispielhaft die Position eines Betrachters B dargestellt, der sich außerhalb des Glanzwinkels befindet. Aufgrund der relativ stark (diffus) streuenden Deckplatte 2 mit äußerer Strukturierung und innen liegender Interferenzschicht finden sich für verschiedene Betrachtungswinkel außerhalb des Glanzwinkels meist passende Lichtwege, die die Interferenzschicht passiert haben. Hierdurch ergibt sich ein Farbeindruck, der weitaus weniger richtungsabhängig ist als bei herkömmlichen Modulen ohne strukturierten Bereich 8.

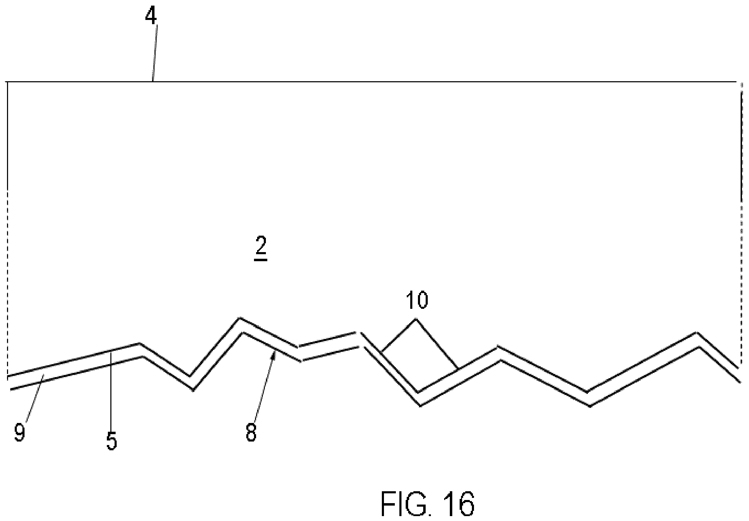

Es wird nun Bezug auf Figur 16 genommen, worin eine Ausgestaltung des erfindungsgemäßen Fassadenelements 1 gemäß dem zweiten Aspekt der Erfindung veranschaulicht ist, wobei lediglich die Deckplatte 2 gezeigt ist. Um unnötige Wiederholungen zu vermeiden, werden nur die Unterschiede zur Ausgestaltung von Figur 14 beschrieben und ansonsten wird auf obige Ausführungen Bezug genommen. Demnach weist das Fassadenelement 1 auf der Innenfläche 5 der Deckplatte 2 einen strukturierten Bereich 8 auf, wobei auf dem strukturierten Bereich 8 eine optische Interferenzschicht 9 angeordnet ist. Die optische Interferenzschicht 9 ist dünn und folgt der Oberfläche des strukturierten Bereichs 8. Der strukturierte Bereich 8 und die optische Interferenzschicht 9 können jeweils analog zu jenen der Ausgestaltung von Figur 14 ausgebildet sein. Die Außenfläche 4 der Deckplatte 2 weist keinen strukturierten Bereich 8 auf und ist im Rahmen der Produktionsungenauigkeiten glatt. Ferner ist keine optische Interferenzschicht auf der Außenfläche 4 angeordnet. Im Unterschied zu den Segmenten 10 des strukturierten Bereichs 8 der Außenfläche 4 der Ausgestaltung von Figur 14, befindet sich auf dem strukturierten Bereich 8 der Innenfläche 5 die optische Interferenzschicht 9, so dass die Segmente 10 die Bedingung zu erfüllen haben, wonach die Segmente 10 des strukturierten Bereichs 8 der Innenfläche 5 jeweils eben sind, eine Segmentfläche von mindestens 1 µm² haben und eine mittlere Rauigkeit von weniger als 15% einer Schichtdicke der optischen Interferenzschicht 9 auf der Innenfläche 5 aufweisen.

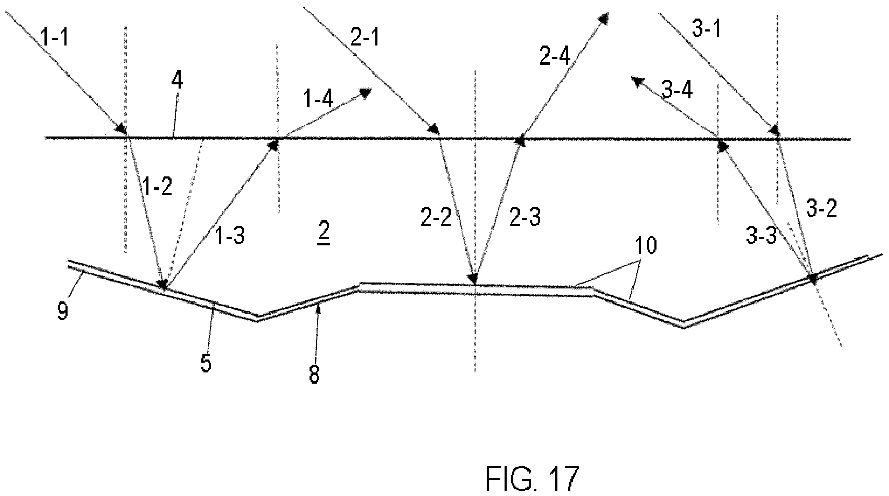

In Figur 17 sind analog zu Figur 15 beispielhaft drei verschiedene Lichtwege für die Ausgestaltung der Deckplatte 2 von Figur 16 gezeigt. Die Reflexion der Lichtstrahlen an der Interferenzschicht 9 ist wiederum vereinfacht dargestellt. Die Ausführungen zu Figur 6 gelten analog. Aufgrund der verschieden geneigten Segmente 10 werden die Lichtstrahlen verschieden von der Deckplatte 2 reflektiert. Ein erster Lichtstrahl 1-1 trifft auf die Außenfläche 4 der Deckplatte 2, quert als gebrochener Lichtstrahl 1-2 die Deckplatte 2, wird als Lichtstrahl 1-3 von einem zur Ebene der Deckplatte 2 geneigten Segment 10 reflektiert, und tritt als gebrochener Lichtstrahl 1-4 von der Deckplatte 2 zur äußeren Umgebung hin aus. In entsprechender Weise trifft ein zweiter Lichtstrahl 2-1 auf die Außenfläche 4 der Deckplatte 2, quert als gebrochener Lichtstrahl 2-2 die Deckplatte 2, wird als Lichtstrahl 2-3 von einem zur Ebene der Deckplatte 2 parallelen Segment 10 reflektiert und tritt als gebrochener Lichtstrahl 2-4 von der Deckplatte 2 zur äußeren Umgebung hin aus. In entsprechender Weise trifft ein dritter Lichtstrahl 3-1 auf die Außenfläche 4 der Deckplatte 2, quert als gebrochener Lichtstrahl 3-2 die Deckplatte 2, wird als Lichtstrahl 3-3 von einem zur Ebene der Deckplatte 2 geneigten Segment 10 reflektiert, und tritt als gebrochener Lichtstrahl 3-4 von der Deckplatte 2 zur äußeren Umgebung hin aus. Lediglich für das mittlere Segment 10 ist für den einfallenden Lichtstrahl 2-1 und ausfallenden Lichtstrahl 2-4 die Bedingung Einfallswinkel = Ausfallswinkel, d.h. Reflexion im Glanzwinkel, erfüllt. Die anderen Lichtstrahlen werden von den Segmenten 10 jeweils im lokalen Glanzwinkel reflektiert, welcher jedoch nicht dem Glanzwinkel der Ebene der Deckplatte 2 entspricht, so dass eine relativ starke Streuung auftritt. In Verbindung mit der optischen Interferenzschicht 9 kann eine wenig richtungsabhängige, homogene Farbwirkung für das Fassadenelement 1 erzielt werden.

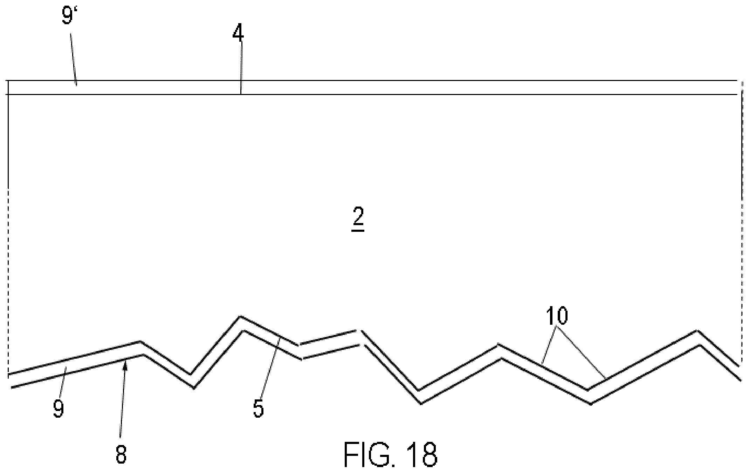

In Figur 18 ist eine weitere Ausgestaltung des erfindungsgemäßen Fassadenelements 1 gemäß dem zweiten Aspekt der Erfindung veranschaulicht, wobei nur die Deckplatte 2 gezeigt ist. Um unnötige Wiederholungen zu vermeiden, werden lediglich die Unterschiede zur Ausgestaltung von Figur 16 beschrieben und ansonsten wird auf obige Ausführungen Bezug genommen. Demnach weist das Fassadenelement 1, neben der optischen Interferenzschicht 9 auf dem strukturierten Bereich 8 der Innenfläche 5 der Deckplatte 2 eine weitere optische Interferenzschicht 9' unmittelbar auf der Außenfläche 4 der Deckplatte 2 auf. Die Außenfläche 4 ist nicht strukturiert, d.h. weist keinen strukturierten Bereich 8 analog zur Innenfläche 5 auf. Vielmehr ist die Außenfläche 4 glatt im Rahmen der Produktionsungenauigkeiten. Die beiden Interferenzschichten 9, 9' können einen gleichen oder verschiedenen optischen Brechungsindex sowie eine gleiche oder verschiedene Schichtdicke haben. Wenn eine gleiche optische Dicke n*d für die beiden optischen Interferenzschichten 9, 9' gewählt wird, kann die Farbe des Solarmoduls 1 verstärkt werden, da das den Beobachter erreichende Licht in Summe dreimal eine optische Interferenzschicht passiert und deshalb stärker gefiltert ist. Bei Beschichtung mit deutlich unterschiedlichen optischen Dicken können Mischfarben generiert werden.

Falls die Außenfläche 4 der Deckplatte 2 mit einer optischen Interferenzschicht 9' beschichtet wird, die aus einer anorganischen, chemisch inerten und harten Schicht wie zum Beispiel Si₃N₄ besteht, ergibt sich eine hohe Kratzfestigkeit, chemische Beständigkeit und schmutzabweisende Wirkung für das Fassadenelement 1. Durch die Verwendung von fotokatalytischen Schichten wie TiO₂ kann sich zudem ein selbstreinigender Effekt ergeben.

Eine solche auf der Außenfläche 4 angeordnete zusätzliche Schicht kann auch eine dünne Antireflexschicht sein, welche einen optischen Brechungsindex aufweist, der kleiner ist als jener der Deckplatte 2. Dadurch wird die im Wesentlichen weiße Reflexion der Deckplatte 2 (z.B. Glas) unterdrückt und der Sättigungsgrad der Farben steigt.

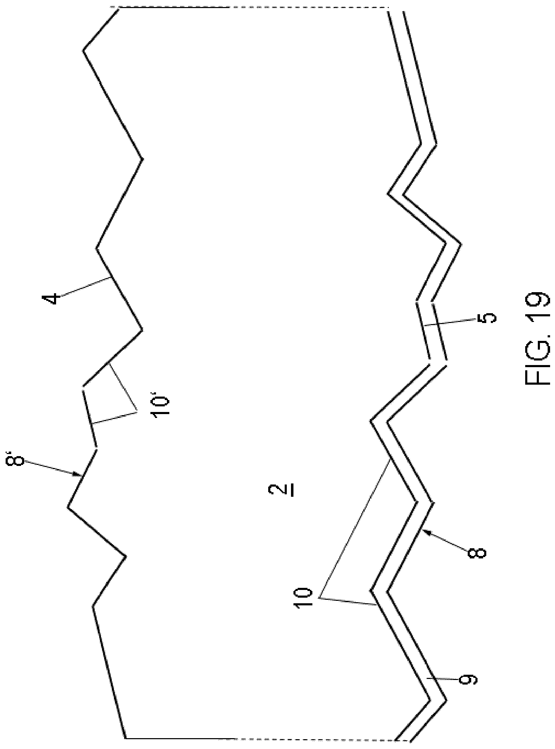

In Figur 19 ist eine weitere Ausgestaltung des erfindungsgemäßen Fassadenelements 1 gemäß dem zweiten Aspekt der Erfindung veranschaulicht, wobei nur die Deckplatte 2 gezeigt ist. Um unnötige Wiederholungen zu vermeiden, werden lediglich die Unterschiede zur Ausgestaltung von Figur 16 beschrieben und ansonsten wird auf obige Ausführungen Bezug genommen. Demnach weist die Innenfläche 5 der Deckplatte 2 des Fassadenelements 1 einen strukturierten Bereich 8 auf, auf dem eine optische Interferenzschicht 9 angeordnet ist. Weiterhin weist auch die Außenfläche 4 der Deckplatte 2 einen strukturierten Bereich 8' auf. Auf der Außenfläche 4 ist keine optische Interferenzschicht angeordnet. Die beiden strukturierten Bereiche 8, 8' können gleich oder voneinander verschieden sein. Im Ausführungsbeispiel von Figur 19 haben alle Segmente 10 einen Neigungswinkel von maximal 45°. Im Unterschied zu den Segmenten 10 des strukturierten Bereichs 8 der Innenfläche 5, gibt es für die Segmente 10' des strukturierten Bereichs 8' der Außenfläche 4 des Fassadenelements 1 von Figur 19 keine Bedingung für die Rauigkeit.

Eine solche auf der Außenfläche 4 angeordnete zusätzliche Schicht kann auch eine dünne, farbneutrale Antireflexschicht sein, welche einen optischen Brechungsindex aufweist, der kleiner ist als jener der Deckplatte 2. Dadurch wird die im Wesentlichen weiße Reflexion der Deckplatte 2 (z.B. Glas) unterdrückt und der Sättigungsgrad der Farben steigt. Eine zusätzliche, auf der Außenfläche 4 angeordnete Schicht kann aber auch den gleichen optischen Brechungsindex wie die Deckplatte 2 aufweisen. In diesem Fall dient die Schicht nur dem Schutz der Deckplatte 2 vor Feuchte und anderen korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Den in den Figuren 14, 16, 18 und 19 beschriebenen Ausgestaltungen des Aspekts der Erfindung ist gemeinsam, dass das Licht mindestens einmal die Deckplatte passieren und an der innenliegenden Interferenzschicht reflektiert werden muss, um nach Austritt aus der Außenfläche die gewünschte Farbigkeit mit der verbesserten Winkelstabilität zu erreichen.

Grundsätzlich kann das Fassadenelement 1 durch eine beliebige geeignete Befestigungstechnik, beispielsweise am Rückseitenelement 3 (z.B. durch Kleben) angebrachte Rückseitenschienen, gebohrte Punkthalter, Klemmleisten usw. an einer Fassade montiert werden. Insbesondere kann das Rückseitenelement 3 passend zum verwendeten Unterkonstruktionssystem zur Befestigung genutzt werden. Häufig kommen in vorgehängt-hinterlüfteten Fassaden Einhängesysteme zum Einsatz, bei denen die Fügeverbindung über einen Formschluss realisiert wird.

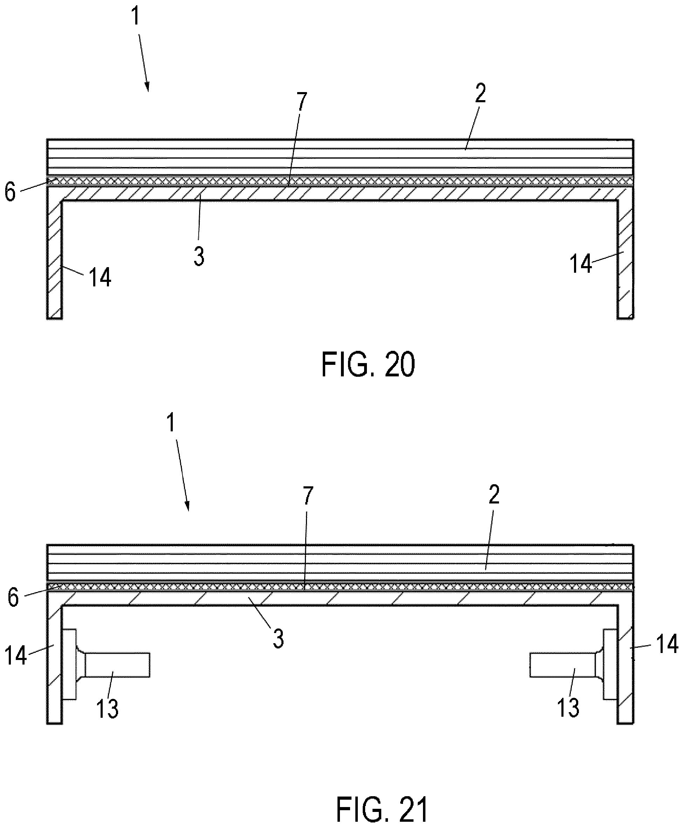

In Figur 20 ist ein Ausführungsbeispiel gezeigt, bei dem an der Deckplatte 2 ein beispielsweise in Form eines Metallblechs ausgebildetes, tragendes Rückseitenelement 3 mittels einer transparenten Klebeschicht 6 (Folie, Gießharz) angebracht ist. Das Metallblech hat eine U-Form und verfügt neben einem plattenförmigen Abschnitt, der eine Kontaktfläche 7 zur Klebung aufweist, über rückseitig abstehende Stützen 14, die für eine Befestigung des Fassadenelements 1 dienen können. Das Metallblech kann insbesondere auch aus einem Metallverbundmaterial bestehen.

In Figur 21 ist eine Variante der Ausgestaltung von Figur 20 gezeigt, bei der an dem als Metallblech ausgebildeten Rückseitenelement 3 an den Stützen 14 jeweils Befestigungselemente 13 durch eine mechanische Verbindung wie z.B. Kleben, Schrauben oder Nieten angebracht sind. Über die Befestigungselemente 13 kann das Fassadenelement 1 beispielsweise formschlüssig mit einer Tragstruktur verbunden werden, um das Fassadenelement 1 in eine Fassade zu integrieren.

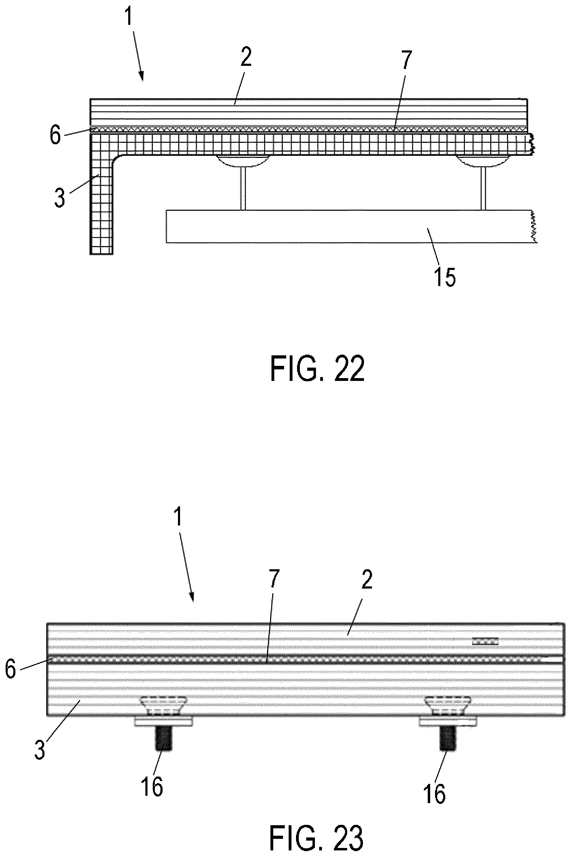

In Figur 22 ist eine weitere Variante veranschaulicht. Hierbei ist das Rückseitenelement 3 in Form einer tragenden, faserverstärkten Betonschale ausgebildet, an dessen Rückseite eine Aufhängung 15 angebracht ist. Über die Aufhängung 15 kann das Fassadenelement 1 in einfacher Weise an einer Tragstruktur befestigt werden.

In Figur 23 ist eine weitere Variante gezeigt, bei der das Rückseitenelement 3 eine tragende Glas-, Stein- oder Keramikplatte ist, in der Hinterschnittanker 16 verankert sind. Über die Hinterschnittanker 16 kann das Fassadenelement 1 in einfacher Weise an einer Tragstruktur befestigt werden.

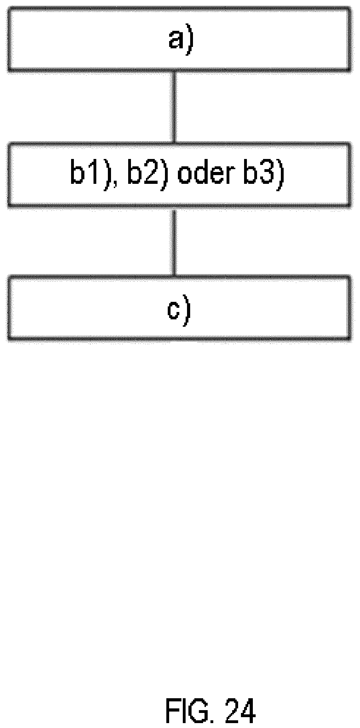

Figur 24 veranschaulicht ein erfindungsgemäßes Verfahren zur Herstellung des erfindungsgemäßen Fassadenelements 1 gemäß dem ersten Aspekt der Erfindung.

Hierbei wird in einem ersten Verfahrensschritt a) eine ebene transparente Deckplatte 2 bereitgestellt, die eine Außenfläche 4, welche der äußeren Umgebung zugewandt sein soll, und eine gegenüberliegende Innenfläche 5 aufweist.

Anschließend wird ein zweiter Verfahrensschritt durchgeführt, der aus den folgenden drei (alternativen) Verfahrensschritten b1), b2) oder b3) frei gewählt ist:
b1) Strukturieren der Außenfläche 4 mindestens in einem Bereich 8 und Aufbringen einer optischen Interferenzschicht 9 auf den strukturierten Bereich 8. Hierbei wird die Innenfläche 5 nicht strukturiert und keine optische Interferenzschicht auf die Innenfläche 5 aufgebracht.
b2) Strukturieren der Außenfläche 4 mindestens in einem Bereich 8, Aufbringen einer optischen Interferenzschicht 9 auf den strukturierten Bereich 8 der Außenfläche 4 und Aufbringen einer weiteren optischen Interferenzschicht 9' auf der Innenfläche 5. In diesem Fall wird die Innenfläche 5 nicht strukturiert.
b3) Strukturieren der Außenfläche 4 mindestens in einem Bereich 8, Aufbringen einer optischen Interferenzschicht 9 auf den strukturierten Bereich 8 der Außenfläche 4, Strukturieren der Innenfläche 5 mindestens in einem Bereich 8 und Aufbringen einer weiteren optischen Interferenzschicht 9' auf den strukturierten Bereich 8 der Innenfläche 5.

Zudem wird in einem dritten Verfahrensschritt c) ein Rückseitenelement 3 an der Innenfläche 5 der Deckplatte 2 angebracht.

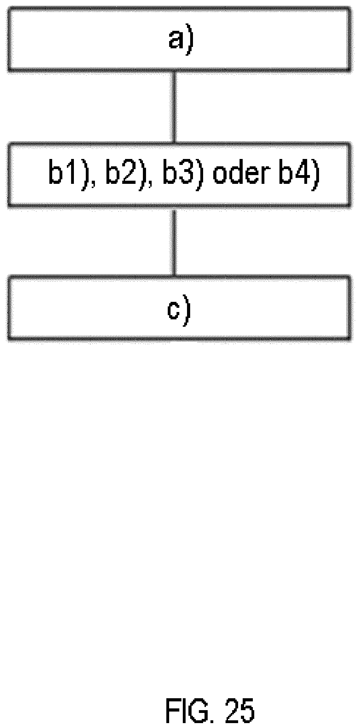

Figur 25 veranschaulicht das erfindungsgemäße Verfahren zur Herstellung des erfindungsgemäßen Fassadenelements 1 gemäß dem zweiten Aspekt der Erfindung.

Hierbei wird in einem ersten Verfahrensschritt a) eine ebene transparente Deckplatte 2 bereitgestellt, die eine Außenfläche 4, welche der äußeren Umgebung zugewandt sein soll, und eine gegenüberliegende Innenfläche 5 aufweist.

Anschließend wird ein zweiter Verfahrensschritt durchgeführt, der aus den folgenden vier (alternativen) Verfahrensschritten b1), b2), b3) oder b4) frei gewählt ist:
b1) Strukturieren der Außenfläche 4 mindestens in einem Bereich und Aufbringen einer optischen Interferenzschicht 9 auf der Innenfläche 5. In diesem Fall wird keine weitere optische Interferenzschicht auf die Außenfläche 4 aufgebracht. Ferner wird die Innenfläche 5 nicht strukturiert.
b2) Strukturieren der Außenfläche 4 mindestens in einem Bereich 8, Strukturieren der Innenfläche 5 mindestens in einem Bereich 8 und Aufbringen einer optischen Interferenzschicht 9 auf den strukturierten Bereich der Innenfläche 5.
   In diesem Fall wird keine weitere optische Interferenzschicht auf die Außenfläche 4 aufgebracht. Ferner wird die Außenfläche 4 nicht strukturiert.
b4) Strukturieren der Innenfläche 5 mindestens in einem Bereich 8, Aufbringen einer optischen Interferenzschicht 9 auf den strukturierten Bereich 8 der Innenfläche 5 und Aufbringen einer weiteren optischen Interferenzschicht 9' auf die Außenfläche 4. In diesem Fall wird die Außenfläche 4 nicht strukturiert.

Zudem wird in einem dritten Verfahrensschritt c) ein Rückseitenelement 3 an der Innenfläche 5 der Deckplatte 2 angebracht.

In Figur 26 ist die Messanordnung zur Bestimmung der diffusen Streuung des erfindungsgemäßen Fassadenelements 1 mit einem kommerziell verfügbaren Mehrwinkel-Farbmessgerät 17 veranschaulicht (Mehrwinkel-Farbmessung). Der nicht näher dargestellte strukturierte Bereich 8 erstreckt sich über die komplette Deckplatte 2 (z.B. Glas). Hierbei wird ein Lichtstrahl auf die Außenfläche 4 des zu charakterisierenden Fassadenelements 1 unter verschiedenen Einfallswinkeln gerichtet und das gestreute bzw. reflektierte Licht aus verschiedenen Beobachtungswinkeln, beispielsweise 15° oder 45° zur Oberflächennormalen der Ebene der Deckplatte 2, spektral vermessen. Unter der Deckplatte 2 befindet sich ein opakes Rückseitenelement 3, das hier beispielsweise als eine schwarze, nicht glänzende Schicht (z.B. angebunden mit einer Flüssigkeit mit Brechungsindex bei etwa 1.5) ausgebildet ist. Mit dem Mehrwinkel-Farbmessgerät 17 kann man die Helligkeit im L-a-b System bei D65 Norm Beleuchtung und 10° Öffnungswinkel bestimmen. Es hat sich gezeigt, dass eine gute Winkelstabilität (d.h. geringe Winkelabhängigkeit des gestreuten Lichts) gegeben ist, wenn sowohl bei 45° als auch bei 15° Beobachtungswinkel und bei einem Einfallswinkel von 45°, jeweils gemessen vom Glanzwinkel, noch mindestens eine Helligkeit von L = 10, bevorzugt L = 15 und noch besser L= 20 vorliegt. Durch den mindestens einen strukturierten Bereich 8 von Außenfläche 4 und/oder Innenfläche 5 der Deckplatte 2 kann sowohl bei 45° als auch bei 15° Beobachtungswinkel und bei einem Einfallswinkel von 45°, jeweils gemessen vom Glanzwinkel (in beiden Richtungen), mindestens eine Helligkeit von L = 10 erreicht werden. Die Gradangaben sind folgendermaßen zu verstehen: Reflexionswinkel (bezogen auf Oberflächennormale/Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 20 ist bei einem Beobachtungswinkel von 45° bzw. 15° relativ zur Oberflächennormalen positioniert.

Wie sich aus vorstehender Erfindungsbeschreibung ergibt, stellt die Erfindung verbesserte Fassadenelemente sowie Verfahren zu deren Herstellung zur Verfügung, die eine sehr homogene, intensive Farbe, bei geringer oder fehlender Richtungsabhängigkeit haben. Die Fassadenelemente können kosteneffizient in verschiedenen Formen und Größen hergestellt werden und in einfacher Weise in eine Fassade integriert werden. Besonders vorteilhaft können die erfindungsgemäßen Fassadenelemente in Kombination mit als Fassadenelementen eingesetzten farbigen Solarmodulen (Farbgebung durch Inteferenzschicht(en), insbesondere CIGS-Dünnschicht-Solarmodulen, eingesetzt werden, wobei eine homogene Farbwirkung der Fassade erzielt werden kann. Hierbei wird erfindungsgemäß der Halbleiterschichtstapel durch andere zumeist kostengünstigere Materialien ersetzt und weitere Elemente wie Anschlussdose, Randversiegelung, Kontaktbändchen und Kabel können eliminiert werden. Besonders vorteilhaft ermöglicht die Erfindung die Herstellung von Passstücken, die insbesondere für den Übergang zu Öffnungen oder den Gebäudekanten notwendig sind. Bei Verwendung von Materialien der Rückseitenelemente, die selbst durch Formschluss fügbar sind, lässen sich zusätzlich Kosten für die Befestigung am Baukörper einsparen. Durch die Verwendung der beschichteten Glaselement und den vorgegebenen optischen Eigenschaften des Rückseitenelements oder des Verbundmaterials wird gewährleistet, dass die photvotaisch passiven Fassadenelemente weitgehend den gleichen Farbeindruck unter verschiedenen Lichtverhältnissen liefern wie die Solarmodule. Wenn nichtrechteckförmige Fassadenelemente zur Ergänzung von Solarmodulen gewünscht sind, können die erfindungsgemäßen Fassadenelemente weitaus kostengünstiger hergestellt werden, als Solarmodule. Die Erfindung stellt somit eine Neuerung zur Verfügung, die in der Praxis des Fassadenbaus erhebliche Vorteile mit sich bringt.

### Bezugszeichenliste

- 1: Fassadenelement
- 2: Deckplatte
- 3: Rückseitenelement
- 4: Außenfläche
- 5: Innenfläche
- 6: Klebeschicht
- 7: Kontaktfläche
- 8, 8': strukturierter Bereich
- 9, 9': optische Interferenzschicht
- 10, 10': Segment
- 11: erste Zone
- 12: zweite Zone
- 13: Befestigungselement
- 14: Stütze
- 15: Aufhängung
- 16: Hinterschnittanker
- 17: Mehrwinkelfarbmessgerät

## Patentansprüche

1. Fassadenelement (1), umfassend eine transparente Deckplatte (2) und ein an der Deckplatte (2) angebrachtes opakes Rückseitenelement (3), wobei die Deckplatte (2) eine der äußeren Umgebung zugewandte Außenfläche (4) und eine dem Rückseitenelement (3) zugewandte Innenfläche (5) hat, wobei gemäß der Alternativen i) und ii)
(i) die Außenfläche (4) mindestens einen strukturierten Bereich (8) aufweist, auf dem eine optische Interferenzschicht (9) zur Reflexion von Licht innerhalb eines vorgegebenen Wellenlängenbereichs angeordnet ist, oder
(ii) auf der Innenfläche (5) eine optische Interferenzschicht (9) zur Reflexion von Licht innerhalb eines vorgegebenen Wellenlängenbereichs angeordnet ist, wobei die Innenfläche (5) und/oder die Außenfläche (4) jeweils mindestens einen strukturierten Bereich (8, 8') aufweist, wobei entweder die Außenfläche (4) mindestens einen strukturierten Bereich (8) aufweist oder auf der Außenfläche (4) eine weitere optische Interferenzschicht (9') zur Reflexion von Licht innerhalb eines vorgegebenen Wellenlängenbereichs angeordnet ist, oder die Innenfläche (5) mindestens einen strukturierten Bereich (8, 8') aufweist und die Außenfläche (4) keinen strukturierten Bereich aufweist, wobei keine optische Interferenzschicht auf der Außenfläche (4) angeordnet ist, und
wobei der strukturierte Bereich (8, 8') folgende Merkmale hat:
- senkrecht zur Ebene der Deckplatte (2) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (8, 8') setzt sich aus Segmenten (10) zusammen, die zur Ebene der Deckplatte (2) geneigt sind, wobei, bezogen auf die Ebene der Deckplatte (2), mindestens 20% der Segmente (10) einen Neigungswinkel im Bereich von größer als 0° bis maximal 15° und mindestens 30% der Segmente (10) einen Neigungswinkel im Bereich von größer als 15° bis maximal 45° haben, wobei gemäß der Alternative i)
- die Segmente (10) jeweils eben sind und eine Segmentfläche von mindestens 1 µm² haben, wobei die Segmente (10) jeweils eine mittlere Rauigkeit von weniger als 15% einer Schichtdicke der optischen Interferenzschicht (9) auf der Außenfläche (4) haben und wobei gemäß der Alternative ii)
- falls die Innenfläche (5) mindestens einen strukturierten Bereich (8') aufweist, die Segmente (10) des strukturierten Bereich (8') der Innenfläche (5) jeweils eben sind, eine Segmentfläche von mindestens 1 µm² und eine mittlere Rauigkeit von weniger als 15% einer Schichtdicke der optischen Interferenzschicht (9) auf der Innenfläche (5) haben.

2. Fassadenelement (1) nach Anspruch 1, Alternative (i), bei welchem die Innenfläche (5) keinen strukturierten Bereich und keine optische Interferenzschicht aufweist.

3. Fassadenelement (1) nach Anspruch 1, Alternative (i), bei welchem die Innenfläche (5) keinen strukturierten Bereich aufweist und auf der Innenfläche (5) der Deckplatte (2) eine weitere optische Interferenzschicht (9') zur Reflexion von Licht innerhalb eines vorgegebenen Wellenlängenbereichs angeordnet ist.

4. Fassadenelement (1) nach Anspruch 1, Alternative (i), bei welchem die Innenfläche (5) mindestens einen strukturierten Bereich (8') aufweist, auf dem eine optische Interferenzschicht (9') zur Reflexion von Licht innerhalb eines vorgegebenen Wellenlängenbereichs angeordnet ist.

5. Fassadenelement (1) nach Anspruch 1, Alternative (ii), bei welchem die Innenfläche (5) der Deckplatte (2) keinen strukturierten Bereich aufweist und die Außenfläche (4) mindestens einen strukturierten Bereich (8) aufweist, wobei keine optische Interferenzschicht auf der Außenfläche (4) angeordnet ist.

6. Fassadenelement (1) nach Anspruch 1, Alternative (ii), bei welchem die Innenfläche (5) der Deckplatte (2) mindestens einen strukturierten Bereich (8) aufweist und die Außenfläche mindestens einen strukturierten Bereich (8') aufweist, wobei keine optische Interferenzschicht auf der Außenfläche (4) angeordnet ist.

7. Fassadenelement (1) nach Anspruch 1, Alternative (ii), bei welchem die Innenfläche (5) der Deckplatte (2) mindestens einen strukturierten Bereich (8) aufweist und die Außenfläche (4) keinen strukturierten Bereich aufweist, wobei eine weitere optische Interferenzschicht (9') auf der Außenfläche (4) angeordnet ist.

8. Fassadenelement (1) nach einem der Ansprüche 1 bis 7, bei welchem das Rückseitenelement (3) ausgebildet ist als:
- eine rückseitige Beschichtung der Deckplatte (2), oder
- eine opake Folie, die durch ein transparentes Klebemittel, insbesondere eine transparente Klebefolie, mit der Deckplatte (2) fest verbunden ist, oder
- ein opaker starrer Körper, der durch ein transparentes Klebemittel, insbesondere eine transparente Klebefolie, mit der Deckplatte (2) fest verbunden ist.

9. Fassadenelement (1) nach einem der Ansprüche 1 bis 7, bei welchem mindestens eine optische Interferenzschicht (9, 9') genau eine Brechungsschicht enthält, wobei die Brechungsschicht einen Brechungsindex n von größer als 1,7, größer als 2,0 oder größer als 2,3 hat.

10. Fassadenelement (1) nach einem der Ansprüche 1 bis 8, bei welchem mindestens eine optische Interferenzschicht (9, 9') genau zwei Brechungsschichten enthält, wobei eine erste Brechungsschicht mit einem ersten Brechungsindex n1 auf der Deckplatte (2) mit einem Brechungsindex nd angeordnet ist und eine zweite Brechungsschicht mit einem zweiten Brechungsindex n2 auf der ersten Brechungsschicht angeordnet ist, wobei für die Absolutwerte der Differenzen der Brechungsindizes gilt:|n1-nd| > 0,3 und |n2-n1| > 0,3, wobei mindestens einer der Brechungsindizes n1 oder n2 größer als 1,9, bevorzugt größer als 2,3, ist.

11. Fassadenelement (1) nach einem der Ansprüche 1 bis 8, bei welchem mindestens eine optische Interferenzschicht (9, 9') genau drei Brechungsschichten enthält, wobei eine erste Brechungsschicht mit einen ersten Brechungsindex n1 auf der Deckplatte (2) mit einem Brechungsindex nd angeordnet ist eine zweite Brechungsschicht mit einem zweiten Brechungsindex n2 auf der ersten Brechungsschicht angeordnet ist und eine dritte Brechungsschicht mit einem dritten Brechungsindex n3 auf der zweiten Brechungsschicht angeordnet ist, wobei für die Absolutwerte der Differenzen der Brechungsindizes gilt: |n3-n2| > 0,3, |n2-n1| > 0,3 und |n1-nd| > 0,3, wobei mindestens einer der Brechungsindizes n1, n2 oder n3 größer als 1,9, bevorzugt größer als 2,3, ist, wobei gilt:
(i) n1 > n2 und n3 > n2, oder (ii) n1 < n2 und n3 < n2.

12. Fassadenelement (1) nach einem der Ansprüche 1 bis 11, bei welchem mindestens 80% oder mindestens 90% mindestens einen strukturierten Bereichs (8) aus zur Ebene der Deckplatte (2) geneigten Segmenten (10) zusammengesetzt ist.

13. Fassadenelement (1) nach einem der Ansprüche 1 bis 11, bei welchem die Deckplatte (2) einen Reflexions-Haze von mehr als 50%, insbesondere mehr als 90%, aufweist.

14. Fassadenelement (1) nach einem der Ansprüche 1 bis 13, bei welchem die mit einer schwarzen Rückfläche versehene, wenigstens einen strukturierten Bereich (8, 8') aufweisende, unbeschichtete Deckplatte (2) so ausgebildet ist, dass bei einem Beobachtungswinkel von 45° und 15° und einem Einfallswinkel, der um 45° vom jeweiligen Glanzwinkel abweicht (in beiden Richtungen), eine Helligkeit L des reflektierten Lichts von mindestens 10, mindestens 15 oder mindestens 20 auftritt.

15. Verfahren zur Herstellung eines Fassadenelements (1) nach Anspruch 1, welches die folgenden Schritte umfasst:
a) Bereitstellen einer transparenten Deckplatte (2) mit einer Außenfläche (4), welche einer äußeren Umgebung zugewandt sein soll, und einer gegenüberliegenden Innenfläche (5), gemäß Alternative (i) einen der folgenden Schritte b1), b2) oder b3):
b1) Strukturieren der Außenfläche (4) mindestens in einem Bereich (8) und Aufbringen einer optischen Interferenzschicht (9) auf den strukturierten Bereich (8),
b2) Strukturieren der Außenfläche (4) mindestens in einem Bereich (8), Aufbringen einer optischen Interferenzschicht (9) auf den strukturierten Bereich (8) und Aufbringen einer weiteren optischen Interferenzschicht (9') auf die Innenfläche (5),
b3) Strukturieren der Außenfläche (4) mindestens in einem Bereich (8), Aufbringen einer optischen Interferenzschicht (9) auf den strukturierten Bereich (8), Strukturieren der Innenfläche (5) mindestens in einem Bereich (8') und Aufbringen einer weiteren optischen Interferenzschicht (9') auf den strukturierten Bereich (8') der Innenfläche (5), oder gemäß Alternative (ii) einen der folgenden Schritte b1), b2) oder b3):
b1) Strukturieren der Außenfläche (4) mindestens in einem Bereich (8) und Aufbringen einer optischen Interferenzschicht auf die Innenfläche (5),
b2) Strukturieren der Außenfläche (4) mindestens in einem Bereich (8), Strukturieren der Innenfläche (5) mindestens in einem Bereich (8') und Aufbringen einer optischen Interferenzschicht (9) auf den strukturierten Bereich (8') der Innenfläche (5),
b3) Strukturieren der Innenfläche (5) mindestens in einem Bereich (8), Aufbringen einer optischen Interferenzschicht (9) auf den strukturierten Bereich (8) der Innenfläche (5) und Aufbringen einer weiteren optischen Interferenzschicht (9') auf die Außenfläche (4), oder die Außenfläche (4) nicht strukturiert und keine optische Interferenzschicht auf der Außenfläche (4) angeordnet wird,
wobei der strukturierte Bereich (8, 8') folgende Merkmale hat:
- senkrecht zur Ebene der Deckplatte (2) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (8, 8') setzt sich aus Segmenten (10, 10') zusammen, die zu einer Ebene der Deckplatte (2) geneigt sind, wobei, bezogen auf die Ebene der Deckplatte (2), mindestens 20% der Segmente (10, 10') einen Neigungswinkel im Bereich von größer als 0° bis maximal 15° und mindestens 30% der Segmente (10, 10') einen Neigungswinkel im Bereich von größer als 15° bis maximal 45° haben, wobei gemäss Alternative (i)
- die Segmente (10, 10') jeweils eben sind und eine Segmentfläche von mindestens 1 µm² haben, wobei die Segmente (10, 10') jeweils eine mittlere Rauigkeit von weniger als 15% einer Schichtdicke der optischen Interferenzschicht (9) auf der Außenfläche (4) haben und wobei gemäß der Alternative ii)
- falls die Innenfläche (5) mindestens einen strukturierten Bereich (8') aufweist, die Segmente (10) des strukturierten Bereich (8') der Innenfläche (5) jeweils eben sind, eine Segmentfläche von mindestens 1 µm2 und eine mittlere Rauigkeit von weniger als 15% einer Schichtdicke der optischen Interferenzschicht (9) auf der Innenfläche (5) haben,
c) Anbringen eines Rückseitenelements (3) an der Innenfläche (5) der Deckplatte (2).

16. Verwendung des Fassadenelements nach einem Ansprüche 1 bis 14 in Kombination mit als Fassadenelementen eingesetzten farbigen Solarmodulen.

## Claims

1. Facade element (1), comprising a transparent cover plate (2) and an opaque back element (3) mounted on the cover plate (2), wherein the cover plate (2) has an outer surface (4) facing the external environment and an inner surface (5) facing the back element (3), wherein measured alternative (i) and alternative (ii):
(i)wherein the outer surface (4) has at least one patterned region (8), on which an optical interference layer (9) for reflecting light within a predefined wavelength range is arranged,
(ii)wherein an optical interference layer (9) for reflecting light within a predefined wavelength range is arranged on the inner surface (5), wherein the inner surface (5) and/or the outer surface (4) has in each case at least one patterned region (8, 8'), wherein either the outer surface (4) has at least one patterned region (8), or another optical interference layer (9') for reflecting light within a predefined wavelength range is arranged on the outer surface (4),or The inner surface (5) has at least one structured area (8, 8') and the auben surface (4) has no structured area, wherein no optical interference layer is arranged on the auben surface (4), and where the structured area (8, 8') has the following characteristics:
- perpendicular to the plane of the cover plate (2), a height profile having hills and valleys, wherein a mean height difference between the hills and valleys is at least 2 p,
- at least 50% of the patterned region (8) is composed of segments (10) that are inclined relative to the plane of the cover plate (2), wherein, with reference to the plane of the cover plate (2), at least 20% of the segments have an inclination angle in the range from greater than 0° to a maximum of 15°, and at least 30% of the segments have an inclination angle in the range from greater than 15° to a maximum of 45°,wherein according to the alternative i)
- the segments (10) are in each case flat and have a segment area of at least 1 pm2, wherein the segments (10) have in each case a mean roughness of less than 15% of a layer thickness of the optical interference layer (9) on the outer surface (4)
and in accordance with the alternative
- if the inner surface (5) has at least one patterned region (8'), the segments (10, 10') of the patterned region (8') of the inner surface (5) are in each case flat, have a segment area of at least 1 pm2 and a mean roughness of less than 15% of a layer thickness of the optical interference layer (9) on the inner surface (5).

2. Facade element (1) according to claim 1 , wherein the inner surface (5) has no patterned region and no optical interference layer.

3. Facade element (1) according to claim 1 , wherein the inner surface (5) has no patterned region and another optical interference layer (9') for reflecting light within a predefined wavelength range is arranged on the inner surface (5) of the cover plate (2).

4. Facade element (1) according to claim 1 , wherein the inner surface (5) has at least one patterned region (8'), on which an optical interference layer (9') for reflecting light within a predefined wavelength range is arranged.

5. Facade element (1) according to claim 5, wherein the inner surface (5) of the cover plate (2) has no patterned region and the outer surface (4) has at least one patterned region (8), wherein no optical interference layer is arranged on the outer surface (4).

6. Facade element (1) according to claim 5, wherein the inner surface (5) of the cover plate (2) has at least one patterned region (8) and the outer surface has at least one patterned region (8'), wherein no optical interference layer is arranged on the outer surface (4).

7. Facade element (1) according to claim 5, wherein the inner surface (5) of the cover plate (2) has at least one patterned region (8) and the outer surface (4) has no patterned region, wherein another optical interference layer (9') is arranged on the outer surface (4).

8. Facade element (1) according to one of claims 1 through 9, wherein the back element (3) is implemented as:a back coating of the cover plate (2), or an opaque film that is fixedly bonded to the cover plate (2) by a transparent adhesive, in particular a transparent adhesive film, or an opaque rigid body that is fixedly bonded to the cover plate (2) by a transparent adhesive, in particular a transparent adhesive film.

9. Facade element (1) according to one of claims 1 through 9, wherein at least one optical interference layer (9, 9') includes exactly one refraction layer, wherein the refraction layer has a refractive index n greater than 1.7, greater than 2.0, or greater than 2.3.

10. Facade element (1) according to one of claims 1 through 10, wherein at least one optical interference layer (9, 9') includes exactly two refraction layers, wherein a first refraction layer with a first refractive index n1 is arranged on the cover plate (2) with a refractive index nd, and a second refraction layer with a second refractive index n2 is arranged on the first refraction layer, wherein the following applies to the absolute values of the differences in the refractive indices: |n1-nd| > 0.3 and |n2-n1| > 0.3, wherein at least one of the refractive indices n1 or n2 is greater than 1.9, preferably greater than 2.3.

11. Facade element (1) according to one of claims 1 through 10, wherein at least one optical interference layer (9, 9') includes exactly three refraction layers, wherein a first refraction layer with a first refractive index n1 is arranged on the cover plate (2) with a refractive index nd, a second refraction layer with a second refractive index n2 is arranged on the first refraction layer, and a third refraction layer with a third refractive index n3 is arranged on the second refraction layer, wherein the following applies to the absolute values of the differences in the refractive indices: |n3-n2| > 0.3, |n2-n1| > 0.3, and |n1-nd| > 0.3, wherein at least one of the refractive indices n1 , n2, or n3 is greater than 1.9, preferably greater than 2.3, wherein the following applies:
(i) n1 > n2 and n3 > n2, or (ii) n1 < n2 and n3 < n2.

12. Facade element (1) according to one of claims 1 through 13, wherein at least 80% or at least 90% of at least one patterned region (8) is composed of segments (10) inclined relative to the plane of the cover plate (2).

13. Facade element (1) according to one of claims 1 through 14, wherein the cover plate (2) has reflection haze of more than 50%, in particular more than 90%.

14. Facade element (1) according to one of claims 1 through 15, wherein the uncoated cover plate (2) provided with a black back surface and having at least one patterned region (8, 8') is implemented such that with a viewing angle 45° and 15° and an angle of incidence that deviates by 45° from the respective glancing angle (in both directions), a brightness L of the reflected light of at least 10, at least 15, or at least 20 occurs.

15. Method for producing a Facade element (1) according to claim 1 , which comprises the following steps:
a) Providing a transparent cover plate (2) with an outer surface (4) that is intended to face an external environment and an opposite inner surface (5),
b1) Patterning the outer surface (4) at least in one region (8), and applying an optical interference layer (9) on the patterned region (8),
b2) Patterning the outer surface (4) at least in one region (8), applying an optical interference layer (9) on the patterned region (8), and applying another optical interference layer (9') on the inner surface (5),
b3) Patterning the outer surface (4) at least in one region (8), applying an optical interference layer (9) on the patterned region (8), patterning the inner surface (5) at least in one region (8'), and applying another optical interference layer (9') on the patterned region (8') of the inner surface (5),or the outer surface (4) is not structured and no optical interference layer is arranged on the outer surface (4)
b1) Patterning the outer surface (4) at least in one region (8), and applying an optical interference layer on the inner surface (5),
b2) Patterning the outer surface (4) at least in one region (8), patterning the inner surface (5) at least in one region (8'), and applying an optical interference layer (9) on the patterned region (8') of the inner surface (5),
B3) Patterning the inner surface (5) at least in one region (8), applying an optical interference layer (9) on the patterned region (8) of the inner surface (5), and applying another optical interference layer (9') on the outer surface (4)
- perpendicular to the plane of the cover plate (2), a height profile having hills and valleys, wherein a mean height difference between the hills and valleys is at least 2 pm,
- at least 50% of the patterned region (8,8') is composed of segments (10,10') that are inclined relative to the plane of the cover plate (2), wherein, with reference to the plane of the cover plate (2), at least 20% of the segments (10,10') have an inclination angle in the range from greater than 0° to a maximum of 15°, and at least 30% of the segments (10, 10') have an inclination angle in the range from greater than 15° to a maximum of 45°, wherein measured according to the alternative (i)
- the segments (10, 10') are in each case flat and have a segment area of at least 1 pm2, wherein the segments (10, 10') have in each case a mean roughness of less than 15% of a layer thickness of the optical interference layer (9) on the outer surface (4),have and wherein according to the alternative (ii)
- if the inner surface (5) has at least one patterned region (8'), the segments (10, 10') of the patterned region (8') of the inner surface (5) are in each case flat, have a segment area of at least 1 pm2 and a mean roughness of less than 15% of a layer thickness of the optical interference layer (9) on the inner surface (5),
c) Mounting a back element (3) on the inner surface (5) of the cover plate (2).

16. Use of the facade element according to one of claims 1 through 16 in combination with colored solar modules used as Facade elements.

## Revendications

1. Élément de façade (1), comprenant une plaque de couverture transparente (2) et un élément arrière opaque (3) monté sur la plaque de couverture (2), dans lequel la plaque de couverture (2) est pourvue d'une surface extérieure (4) face à l'environnement extérieur et d'une surface intérieure (5) face à l'élément arrière (3),
(i) dans lequel la surface extérieure (4) est pourvue d'au moins une zone à motifs (8) dans laquelle est prévue d'une couche d'interférence optique (9) pour réfléchir des lumières dans une plage de longueurs d'onde prédéfinie,ou
(ii) la surface intérieure (5) et/ou la surface extérieure (4) est pourvue d'au moins une zone à motifs (8, 8') en tout cas, soit la surface extérieure (4) est pourvue d'au moins une zone à motifs (8), soit une autre couche d'interférence optique (9') pour réfléchir des lumières dans une plage de longueurs d'onde prédéfinie est prévue sur la surface extérieure (4)
La surface interne (5) a au moins une zone structurée (8, 8') et la surface auben (4) n'a pas de zone structurée, dans laquelle aucune couche d'interférence optique n'est disposée sur la surface auben (4), et
la zone à motifs (8, 8') présentant les caractéristiques suivantes :
- un profil de hauteur perpendiculaire au plan de la plaque de couverture (2), le profil de hauteur présentant des collines et des vallées, et une différence de hauteur moyenne entre les collines et les vallées étant d'au moins 2 µm,
- au moins 50 % de la zone à motifs (8) étant composée de segments (10) inclinés par rapport au plan de la plaque de couverture (2), en référence au plan de la plaque de couverture (2), au moins 20 % des segments (10) formant un angle d'inclinaison dans une plage de 0° jusqu'à 15° au maximum, et au moins 30 % des segments (10) formant un angle d'inclinaison dans une plage de 15° jusqu'à 45° au maximum,dans laquelle selon l'alternative i)
- les segments (10) étant plats en tout cas et présentant une surface de segment d'au moins 1 µm², et les segments (10) présentant une rugosité moyenne inférieure à 15 % d'une épaisseur de la couche d'interférence optique (9) sur la surface extérieure (4) en tout cas.dans laquelle selon l'alternative ii)
- la surface intérieure (5) étant pourvue d'au moins une zone à motifs (8'), les segments (10, 10') dans la zone à motifs (8') de la surface intérieure (5) étant plats en tout cas, et présentant une surface de segment d'au moins 1 µm² et une rugosité moyenne inférieure à 15 % d'une épaisseur de la couche d'interférence optique (9) sur la surface extérieure (5) en tout cas.

2. Élément de façade (1) selon la revendication 1, dans lequel la surface intérieure (5) n'est pas pourvue de zone à motifs ni couche d'interférence optique.

3. Élément de façade (1) selon la revendication 1, dans lequel la surface intérieure (5) n'est pas pourvue de zone à motifs et une autre couche d'interférence optique (9') pour réfléchir des lumières dans une plage de longueurs d'onde prédéfinie est prévue sur la surface intérieure (5) de la plaque de couverture (2).

4. Élément de façade (1) selon la revendication 1, dans lequel la surface intérieure (5) est pourvue d'au moins une zone à motifs (8') et une couche d'interférence optique (9') pour réfléchir des lumières dans une plage de longueurs d'onde prédéfinie est prévue dans la zone à motifs.

5. Élément de façade (1) selon la revendication 5, dans lequel la surface intérieure (5) de la plaque de couverture (2) n'est pas pourvue de zone à motifs, la surface extérieure (4) est pourvue d'au moins une zone à motifs (8), et aucune couche d'interférence optique n'est prévue sur la surface extérieure (4).

6. Élément de façade (1) selon la revendication 5, dans lequel la surface intérieure (5) de la plaque de couverture (2) est pourvue d'au moins d'une zone à motifs (8), la surface extérieure est pourvue d'au moins une zone à motifs (8'), et aucune couche d'interférence optique n'est prévue sur la surface extérieure (4).

7. Élément de façade (1) selon la revendication 5, dans lequel la surface intérieure (5) de la plaque de couverture (2) est pourvue d'au moins d'une zone à motifs (8), la surface extérieure (4) n'est pas pourvue de zone à motifs, et une autre couche d'interférence optique (9') est prévue sur la surface extérieure (4).

8. Élément de façade (1) selon l'une quelconque des revendications 1 à 9, dans lequel l'élément arrière (3) est mise en œuvre comme :
- un revêtement arrière de la plaque de couverture (2), ou
- un film opaque qui est lié de manière fixe à la plaque de couverture (2) par un adhésif transparent, en particulier un film adhésif transparent, ou
- un corps rigide opaque qui est lié de manière fixe à la plaque de couverture (2) par un adhésif transparent, en particulier un film adhésif transparent.

9. Élément de façade (1) selon l'une des revendications 1 à 9, dans lequel au moins une couche d'interférence optique (9, 9') comprend exactement une couche réfractrice, la couche réfractrice présentant un indice de réfraction n supérieur à 1,7, supérieur à 2,0, ou supérieur à 2,3.

10. Élément de façade (1) selon l'une des revendications 1 à 10, dans lequel au moins une couche d'interférence optique (9, 9') comprend exactement deux couches réfractrices, une première couche réfractrice à un premier indice de réfraction n1 étant prévue sur le plaque de couverture (2) à un indice de réfraction nd, et une deuxième couche réfractrice à un deuxième indice de réfraction n2 étant prévue sur la première couche réfractrice, et une valeur absolue de la différence des indices de réfraction satisfaisant une relation suivante : |n1-nd| > 0,3 et |n2-n1| > 0,3,
où au moins l'un des indices de réfraction n1 et n2 est supérieur à 1,9, de préférence supérieur à 2,3.

11. Élément de façade (1) selon l'une des revendications 1 à 10, dans lequel au moins une couche d'interférence optique (9, 9') comprend exactement trois couches réfractrices, une première couche réfractrice à un premier indice de réfraction n1 étant prévue sur le plaque de couverture (2) à un indice de réfraction nd, une deuxième couche réfractrice à un deuxième indice de réfraction n2 étant prévue sur la première couche réfractrice, et une troisième couche réfractrice à un troisième indice de réfraction n3 étant prévue sur la deuxième couche réfractrice, et une valeur absolue de la différence des indices de réfraction satisfaisant une relation suivante : |n3-n2| > 0,3, |n2-n1| > 0,3, et |n1-nd| > 0,3, où au moins l'un des indices de réfraction n1, n2 et n3 est supérieur à 1,9, de préférence supérieur à 2,3, avec : n1 > n2 et n3 > n2, ou (ii) n1 < n2 et n3 < n2.

12. Élément de façade (1) selon l'une quelconque des revendications 1 à 13, dans lequel au moins 80 % ou au moins 90 % d'au moins une zone à motifs (8) est composée de segments (10) inclinés par rapport au plan de la plaque de couverture (2).

13. Élément de façade (1) selon l'une quelconque des revendications 1 à 14, dans lequel la plaque de couverture (2) présente un voile de réflexion supérieur à 50 %, en particulier supérieur à 90 %.

14. Élément de façade (1) selon l'une des revendications 1 à 15, dans lequel la plaque de couverture (2) non revêtue qui est pourvue d'une surface arrière noire et d'au moins une zone à motifs (8, 8') est mise en œuvre afin qu'une luminosité L de la lumière réfléchie soit d'au moins 10, d'au moins 15 ou d'au moins 20 lorsqu'un angle visuel est de 45° et de 15° et qu'un angle d'incidence s'écarte de 45° par rapport d'un angle d'effleurement correspondant (dans les deux directions).

15. Procédé de production d'un élément de façade (1) selon la revendication 1 comprenant les étapes suivantes :
a) fournir une plaque de couverture transparente (2), qui est pourvue d'une surface extérieure (4) face à l'environnement extérieur et d'une surface intérieure (5) opposée,
b1) mettre des motifs sur la surface extérieure (4) au moins dans une zone (8), et appliquer une couche d'interférence optique (9) sur la zone à motifs (8), ou
b2) mettre des motifs sur la surface extérieure (4) au moins dans une zone (8), appliquer une couche d'interférence optique (9) sur la zone à motifs (8) et appliquer une autre couche d'interférence optique (9') sur la surface intérieure (5), ou
b3) mettre des motifs sur la surface extérieure (4) au moins dans une zone (8), appliquer une couche d'interférence optique (9) sur la zone à motifs (8), mettre des motifs sur la surface intérieure (5) au moins dans une zone (8'), et appliquer une autre couche d'interférence optique (9') sur la zone à motifs (8') de la surface intérieure (5),ou, conformément à l'autre (ii) l'un des points suivants b1), b2) ou b3):
b1) mettre des motifs sur la surface extérieure (4) au moins dans une zone (8), et appliquer une couche d'interférence optique sur la surface intérieure (5),
b2) mettre des motifs sur la surface extérieure (4) au moins dans une zone (8), mettre des motifs sur la surface intérieure (5) au moins dans une zone (8'), et appliquer une couche d'interférence optique (9) sur la zone à motifs (8') de la surface intérieure (5),
b3) mettre des motifs sur la surface intérieure (5) au moins dans une zone (8), appliquer une couche d'interférence optique (9) sur la zone à motifs (8) de la surface intérieure (5), et appliquer une autre couche d'interférence optique (9') sur la surface extérieure (4),
soit la surface extérieure (4) n'est pas structurée et aucune couche d'interférence optique n'est disposée sur la surface extérieure (4);
la zone à motifs (8, 8') présente les caractéristiques suivantes :
- un profil de hauteur perpendiculaire au plan de la plaque de couverture (2), le profil de hauteur présentant des collines et des vallées, et une différence de hauteur moyenne entre les collines et les vallées étant d'au moins 2 µm,
- au moins 50 % de la zone à motifs (8, 8') étant composée de segments (10, 10') inclinés par rapport au plan de la plaque de couverture (2), en référence au plan de la plaque de couverture (2), au moins 20 % des segments (10, 10') formant un angle d'inclinaison dans une plage de 0° jusqu'à 15° au maximum, et au moins 30 % des segments (10, 10') formant un angle d'inclinaison dans une plage de 15° jusqu'à 45° au maximum,
- les segments (10, 10') dans la zone à motifs (8') de la surface intérieure (5) étant plats en tout cas, et présentant une surface de segment d'au moins 1 µm² et une rugosité moyenne inférieure à 15 % d'une épaisseur de la couche d'interférence optique (9) sur la surface extérieure (5) en tout cas, c) monter l'élément arrière (3) sur la surface intérieure (5) de la plaque de couverture (2).

16. Utilisation d'un élément de façade selon l'une quelconque des revendications 1 à 16 en combinaison avec un module solaire coloré utilisé comme élément de façade.
